# EUROPEAN PATENT APPLICATION

(11) **EP 3 343 642 A1**
(43) Date of publication of application: **04.07.2018**
(21) Application number: 17207287.8
(22) Date of filing: 14.12.2017
(51) Int. Cl.: H01L 31/101, H01L 31/02, H01L 31/0304, H01L 31/0352, H01L 27/146, G01J 5/20

(54) **PHOTODETECTOR AND METHOD FOR WAVELENGTH PEAK SENSITIVITY CALIBRATION**

(30) Priority: 16.12.2016 JP 2016244423; 27.11.2017 JP 2017226949; 27.11.2017 JP 2017226950
(71) Applicant: Sharp Kabushiki Kaisha, Sakai-shi Osaka 590-8522 (JP); The University Of Tokyo, Tokyo 113-8654 (JP)
(72) Inventor: KOTANI, Teruhisa, Osaka, 590-8522 (JP); YOSHIKAWA, Hirofumi, Osaka, 590-8522 (JP); KITAZAWA, Tazuko, Osaka, 590-8522 (JP); ARAKAWA, Yasuhiko, Tokyo, 113-8654 (JP); KWOEN, Jinkwan, Tokyo, 113-8654 (JP)
(74) Representative: Müller Hoffmann & Partner

(57) **Abstract**

A photodetector (11A, 11B, 51) includes an active layer containing a quantum well or quantum dots (14A, 14B, 56) and the detector (11A, 11B, 51) can shift a detection peak (1A, 1B) by applying a voltage to the active layer. The detector (11A, 11B, 51) has a reference wavelength (3) to be referred to as a criterion for calibration or correction of the detection peak within a range in which the detection peak can be shifted. A method of calibrating or correcting with the detector (11A, 11B, 51) a detection peak (1A, 1B) with the reference wavelength (3) being defined as the criterion is provided.

## Description

This nonprovisional application is based on Japanese Patent Applications Nos. 2016-244423, 2017-226949 and 2017-226950 filed with the Japan Patent Office on December 16, 2016, November 27, 2017 and November 27, 2017, respectively, the entire contents of which are hereby incorporated by reference.

### BACKGROUND OF THE INVENTION

### Field of the Invention

The present invention relates to a detector capable of detecting infrared rays or the like.

### Description of the Background Art

An infrared photodetector of a quantum dot type has conventionally been known as an infrared photodetector which detects infrared rays, the infrared photodetector including a layer structure of an intermediate layer and a quantum dot layer having a narrower band gap than the intermediate layer and including a plurality of quantum dots alternately stacked, and detecting a photocurrent generated by excitation of electrons in the quantum dots when infrared radiation is applied to the layer structure to thereby detect the infrared radiation.

For example, Japanese Patent Laying-Open No. 2009-65141 (Patent Document 1) discloses an infrared photodetector including a layer structure of an intermediate layer and a quantum dot layer having a narrower band gap than the intermediate layer and including a plurality of quantum dots alternately stacked, and detecting a photocurrent generated when infrared radiation is applied to the layer structure to thereby detect the infrared radiation, the infrared photodetector further including a first barrier layer provided on one side of the quantum dot layer and having a larger band gap than the intermediate layer and a second barrier layer provided on the other side of the quantum dot layer and having a larger band gap than the intermediate layer. According to such an infrared photodetector disclosed in Patent Document 1, an infrared photodetector which achieves desired long-wavelength characteristics, is low in dark current, and has sufficient sensitivity can advantageously be achieved.

### SUMMARY OF THE INVENTION

In an infrared photodetector making use of intersubband transition such as a quantum dot infrared photodetector (QDIP) and a quantum well infrared photodetector (QWIP), however, absorption energy is determined by a difference between a ground state of electrons confined in a quantum structure and an excitation state which is a transition target. Positions of the ground state and the excitation state are very sensitive to the quantum structure itself (a shape and a composition), and a wavelength may be varied by 0.05 µm, for example, by variation in height of a quantum dot by only one molecular layer. In general, a density of quantum dots in a photodetector containing quantum dots is from 10¹⁰ to 10¹² cm⁻². Since it is very difficult to form uniform quantum dots under a current quantum dot fabrication technique, an absorption spectrum (a detection spectrum) of the quantum dot infrared photodetector has been known to have a certain width (resulting from variation in quantum dot structure). For example, if an average and a variance of a quantum dot structure (a composition or a shape) per area of an infrared photodetector is identical over the entire surface of one wafer, centers and widths of detection spectra of a plurality of infrared photodetectors fabricated with the wafer described previously are all uniform. It has generally been known, however, that an average or a variance of the quantum dot structure described above is actually different from place to place of the wafer due to variation in temperature or variation in supply of a source material of a quantum dot formation apparatus. Since the quantum dot structure described above has been different depending on a lot even with the same quantum dot formation apparatus due to contamination in the apparatus, the detection spectrum is different for each infrared photodetector and variation has been considerable. This may be because, for example, of a size and a density of quantum dots and a manufacturing error in a quantum structure such as a quantum well. In an application aiming only at sensing of a heat source, influence by the variation is less. In consideration of an application, for example, to a device of which accuracy is significantly affected by a wavelength of a detection peak such as a contactless thermometer or a thermograph, however, variation in detection peak due to a manufacturing error will give rise to a serious problem.

The present invention was made to solve the problems above, and an object thereof is to provide a detector capable of calibrating or correcting variation in detection wavelength of the detector including a detection spectrum in an infrared photodetector and a method of calibrating or correcting variation in detection wavelength of a detector including a detection spectrum in an infrared photodetector.

The present invention is directed to a detector including an active layer containing a quantum well or quantum dots, the detector being capable of shifting a detection wavelength by applying a voltage to the active layer, the detector having a reference wavelength to be referred to as a criterion for calibration or correction of the detection wavelength within a wavelength region in which the detection wavelength can be shifted. According to the present configuration, a detection wavelength can be calibrated or corrected with a reference wavelength and a highly accurate detector is obtained.

The detector according to the present invention is preferably configured to calibrate or correct the detection wavelength with the reference wavelength being defined as the criterion. According to the present configuration, the detection wavelength is accurate and hence measurement accuracy is high. Since variation in production can be accommodated, costs in a production process can be reduced.

In the detector according to the present invention, preferably, the reference wavelength is a wavelength at the time when a detection value from the detector exhibits a relative maximum value, a relative minimum value, a rising edge, or a falling edge. According to the present configuration, the reference wavelength can readily be measured. For example, an emission peak or an absorption peak can be defined as the reference wavelength. In this case, preferably, the detector is configured to calibrate or correct the detection wavelength with a value of the voltage applied to the active layer at the time when the detection value exhibits the relative maximum value, the relative minimum value, the rising edge, or the falling edge. According to the present configuration, relation between an applied voltage and a wavelength is clarified.

The detector according to the present invention may be configured to set a wavelength at which a value of the voltage applied to the active layer is detected at a median which is substantially at the center of a range of applied voltages as the reference wavelength and to set a difference between the value of the voltage applied to the active layer at the time when a detection value from the detector exhibits a relative maximum value, a relative minimum value, a rising edge, or a falling edge and the median as an offset voltage. According to the present configuration, the possibility that a peak which is referred to is out of a range of applied voltages due to occurrence of variation for each element is low.

The detector according to the present invention may be configured to calibrate or correct the detection wavelength with a plurality of reference wavelengths.
According to the present configuration, a wavelength can more accurately be calibrated or corrected. In this case, the detector may be configured to set a wavelength detected when a value of the voltage applied to the active layer is set to a value other than 0 V as one of reference wavelengths.

Preferably, the detector according to the present invention is capable of detecting infrared rays and an absorption spectrum specific to a gas is defined as the reference wavelength. In this case, more preferably, the gas is contained in air, and particularly preferably, the gas is carbon dioxide or water vapor. According to the present configuration, calibration or correction can be performed in a simplified manner by using an absorption peak wavelength of a gas in the air.

In the detector according to the present invention, an emission peak may be defined as the reference wavelength. According to the present configuration, the reference wavelength can readily be determined.

Preferably, the detector according to the present invention further includes a substrate, and the reference wavelength is a wavelength at which a transmittance of the substrate exhibits a relative maximum value, a relative minimum value, a rising edge, or a falling edge. According to the present configuration, the detection wavelength can be calibrated or corrected with the wavelength at which a transmittance of the substrate exhibits the relative maximum value, the relative minimum value, the rising edge, or the falling edge, and a highly accurate detector is obtained.

The detector according to the present invention is preferably configured to calibrate or correct the detection wavelength with a wavelength at which the transmittance of the substrate exhibits the relative maximum value, the relative minimum value, the rising edge, or the falling edge being defined as the criterion. According to the present configuration, the detection wavelength is accurate and hence measurement accuracy is high. Since variation in production can be accommodated, costs in a production process can be reduced.

In the detector according to the present invention, a photoelectric conversion unit including the active layer containing the quantum well or the quantum dots may integrally be formed on the substrate, or the substrate may be provided separately from a photoelectric conversion unit including the active layer containing the quantum well or the quantum dots. According to the integrally formed configuration, the detector integrated with the substrate alone can achieve calibration or correction and there is no influence by an assembly error. According to the configuration in which the substrate is separately provided, the substrate can be attached only at the time of calibration or correction, and hence there is no influence by variation in transmittance of the substrate in detection. Since a substrate is replaceable, a wavelength at which a transmittance of the substrate defined as the criterion for calibration or correction exhibits the relative maximum value, the relative minimum value, the rising edge, or the falling edge can advantageously be adjusted in accordance with the detection wavelength.

In the detector according to the present invention, the substrate is preferably composed of silicon. In this case, the substrate has a resistance value preferably not higher than 1000 Ω·cm. In this case, the substrate is preferably an on-axis Silicon substrate. According to the present configuration, calibration or correction can be enabled because silicon is capable of absorption around a wavelength of 9 µm. Furthermore, a photoelectric conversion unit is more readily integrally formed on the substrate. An on-axis Silicon substrate would be particularly suitable for a large-scale image sensor.

In the detector according to the present invention, the substrate may be composed of a resin. According to the present configuration, a wavelength absorbed by the substrate which is defined as the criterion for calibration or correction can advantageously be adjusted in accordance with the detection wavelength.

The present invention also provides a method of calibrating a detector with the detector according to the present invention described above, in which a detection wavelength is calibrated with a reference wavelength being defined as the criterion.

The present invention also provides a method of correcting a detector with the detector according to the present invention described above, in which a detection wavelength is corrected with a reference wavelength being defined as the criterion.

According to the present invention, a detector capable of compensating for variation in detection spectrum due to a manufacturing error in a simplified manner through calibration or correction, such as an infrared photodetector, and a method of calibrating or correcting the detector can be provided.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Figs. 1A and 1B are diagrams schematically showing a method of calibrating an infrared photodetector according to the present invention.
Fig. 2A is a diagram schematically showing infrared photodetectors 11A and 11B representing preferred examples of the present invention.
Fig. 2B is a partially enlarged view of Fig. 2A.
Fig. 3 is a diagram schematically showing electrodes 16A and 17A of infrared photodetector 11A shown in Fig. 2A being electrically connected to a power supply 18A.
Fig. 4 shows a detection spectrum schematically showing a detection peak when various voltages are applied to infrared photodetector 11A shown in Fig. 3.
Fig. 5A is a diagram showing an infrared transmission spectrum of carbon dioxide (CO₂).
Fig. 5B is a diagram showing the detection spectrum shown in Fig. 4 on which an absorption line of carbon dioxide (CO₂) is superimposed.
Fig. 5C shows a graph of a result of detection of a signal (a detection signal) of outside light (solar rays) while a value of a voltage V applied to infrared photodetector 11A is varied.
Fig. 6 is a diagram schematically showing electrodes 16A and 17A of infrared photodetector 11A shown in Fig. 2A being electrically connected to power supply 18A and electrodes 16B and 17B of infrared photodetector 11B being electrically connected to a power supply 18B.
Fig. 7A is a diagram of a detection spectrum representing each detection peak in a state that no voltage is applied in infrared photodetectors 11A and 11B shown in Fig. 6 (V_{A} ∼ 0 V and V_{B} ∼ 0 V) on which an absorption peak wavelength of carbon dioxide (CO₂) is superimposed.
Fig. 7B shows a graph of a result of detection of a signal (a detection signal) of outside light (solar rays) while voltage values V_{A} and V_{B} applied to infrared photodetectors 11A and 11B are varied.
Figs. 8A and 8B show detection spectra of infrared photodetectors 11A and 11B when solar rays are detected.
Fig. 9 is a diagram schematically showing an infrared photodetector 31 in another preferred example of the present invention.
Fig. 10 shows one exemplary block diagram of the infrared photodetector according to the present invention.
Fig. 11 shows another exemplary block diagram of the infrared photodetector according to the present invention.
Fig. 12 is a flowchart showing exemplary control of an infrared photodetector in Embodiment 1.
Fig. 13 is a flowchart showing exemplary control of an infrared photodetector in Embodiment 4.
Fig. 14 is a flowchart showing exemplary control of an infrared photodetector in Embodiment 5.
Fig. 15 is a diagram schematically showing an infrared photodetector 51 in Embodiment 6.
Fig. 16 is a partially enlarged view of an InₓGa₁₋ₓAs quantum dot (0 ≤ x ≤ 1)/In_{y}Ga_{1-y}As (0 ≤ y < 1)/Al_{z}Ga_{1-z}As (0 ≤ z ≤ 1) matrix 56 in Fig. 15.
Fig. 17 is a diagram schematically showing electrodes 58 and 59 of infrared photodetector 51 shown in Fig. 15 being electrically connected to a power supply.
Fig. 18 shows a detection spectrum schematically showing a detection peak when various voltages are applied to infrared photodetector 51 shown in Fig. 17.
Fig. 19A shows one exemplary block diagram of the infrared photodetector in Embodiment 6.
Fig. 19B shows another exemplary block diagram of the infrared photodetector in Embodiment 6.
Fig. 20A shows infrared transmission spectra of a silicon substrate and a semi-insulating GaAs substrate.
Fig. 20B is a diagram showing the detection spectrum shown in Fig. 18 on which an absorption peak wavelength of the silicon substrate is superimposed.
Fig. 20C shows a graph of a result of detection of a signal (a detection signal) of outside light (solar rays) while a value of voltage V applied to infrared photodetector 51 is varied.
Figs. 21A and 21B are diagrams for illustrating a calibration method with the infrared photodetector in Embodiment 6.
Fig. 22 is a diagram for illustrating the calibration method with the infrared photodetector in Embodiment 6.
Fig. 23 is a flowchart showing one example of control of the infrared photodetector in Embodiment 6.
Figs. 24A, 24B, and 24C are schematic diagrams for illustrating use of a plurality of detectors.
Figs. 25A, 25B, and 25C are diagrams for illustrating a calibration method when a plurality of infrared photodetectors as shown in Figs. 24A, 24B, and 24C are used.
Figs. 26A and 26B are diagrams for illustrating the calibration method when the plurality of infrared photodetectors as shown in Figs. 24A, 24B, and 24C are used.
Fig. 27 is a diagram schematically showing an example in which a plurality of infrared photodetectors are arrayed to form an imaging device 72.
Fig. 28 shows a graph showing a range of wavelengths which can be detected by each infrared photodetector within a range between limits of applied voltages.
Fig. 29 is a diagram schematically showing an infrared photodetector 81 in another preferred example of the present invention.
Fig. 30 is a flowchart showing exemplary control of an infrared photodetector in Embodiment 12.
Fig. 31 is a flowchart showing exemplary control of an infrared photodetector in Embodiment 13.

### DESCRIPTION OF THE PREFERRED EMBODIMENTS

### <Embodiment 1>

The present invention is directed to a detector including an active layer containing a quantum well or quantum dots, the detector being capable of shifting a detection wavelength by applying a voltage to the active layer, the detector having a reference wavelength to be referred to as a criterion for calibration or correction of the detection wavelength within a wavelength region in which the detection wavelength can be shifted. The detector according to the present invention is preferably configured to calibrate or correct a detection wavelength with the reference wavelength being defined as the criterion. Initially, an infrared photodetector is exemplified as a detector according to the present invention, and calibration of the infrared photodetector (a method of calibrating an infrared photodetector) is described. Though a range of application voltages is set to a range from -1 V to +1 V by way of example and 0 V which is substantially the median thereof corresponds to a reference wavelength in the present embodiment, limitation thereto is not intended so long as substantially the median in the range of applied voltages is defined as the reference wavelength.

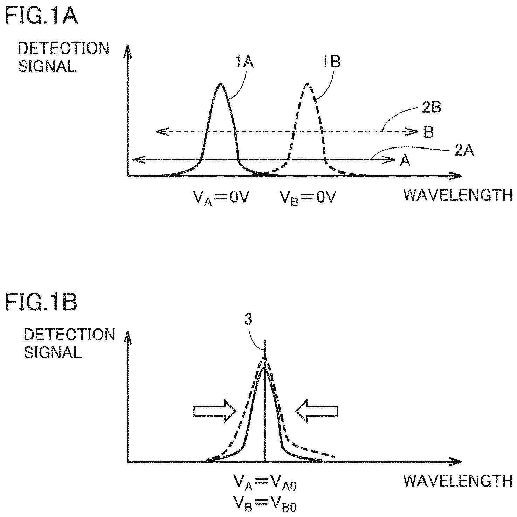

Fig. 1A schematically shows a detection peak detected by the infrared photodetector before the method of calibrating an infrared photodetector according to the present invention is applied, and Fig. 1B schematically shows a detection peak detected by the infrared photodetector when the method of calibrating an infrared photodetector according to the present invention is applied. In Figs. 1A and 1B, the ordinate represents a detection signal and the abscissa represents a wavelength (a unit of µm). In the example shown in Fig. 1A, for example, a detection peak 1A on the left represents a detection peak detected by an infrared photodetector A (smaller in size of a quantum dot or smaller in width of a quantum well) and a detection peak 1B on the right shows a detection peak detected by an infrared photodetector B (greater in size of a quantum dot or greater in width of a quantum well).

The method of calibrating an infrared photodetector according to the present invention is premised on application to an infrared photodetector in which an active layer (a light absorption layer) contains a quantum well or quantum dots. The infrared photodetector in which the active layer contains a quantum well or quantum dots can shift a position of a detection peak depending on an applied voltage. The present invention is directed to a method of calibrating an infrared photodetector in which an active layer contains a quantum well or quantum dots characterized in including the step of applying a voltage at a prescribed value (an offset value) to the infrared photodetector.

In Fig. 1A, a solid line 2A shows a region of wavelengths which can be shifted by application of a voltage in infrared photodetector A and a dotted line 2B shows a region of wavelengths which can be shifted by application of a voltage in infrared photodetector B. Fig. 1A shows detection spectra 1A and 1B of infrared photodetectors A and B while no voltage is applied (that is, a value of a voltage applied in infrared photodetector A (V_{A} = 0 V) and a value of a voltage applied in infrared photodetector B (V_{B} = 0 V)).

The method of calibrating an infrared photodetector according to the present invention preferably includes the step of determining an offset value from an absorption line (a reference wavelength) defined as the criterion. In the example shown in Fig. 1B, a value of a voltage (an offset value of V^{OFF}) applied to the infrared photodetector is determined such that a peak value of a detection peak is superimposed on a reference wavelength 3 and a voltage at the determined voltage value is applied to infrared photodetectors A and B (a value of a voltage applied in infrared photodetector A (V_{A} = V_{A0}) and a value of a voltage applied in infrared photodetector B (V_{B} = V_{B0}) being assumed), so that a position of detection peak 1A is shifted to the right over the sheet plane in Figs. 1A and 1B and a position of detection peak 1B is shifted to the left over the sheet plane in Figs. 1A and 1B.

In the method of calibrating an infrared photodetector according to the present invention, the reference wavelength is not particularly restricted, however, it is preferably set to an absorption peak wavelength of an absorption spectrum specific to a gas. Reference wavelength 3 shown in Fig. 1B exhibits an absorption peak wavelength of an absorption spectrum specific to a gas. The method of calibrating an infrared photodetector according to the present invention preferably includes the step of detecting a detection peak in a specific wavelength region including an absorption spectrum specific to a gas. In the present invention, the "specific wavelength region" refers to a range of wavelengths in which a position of the detection peak can be shifted by application of a voltage, and it is preferably a wavelength region in a range from 2 µm to 7 µm with the absorption peak wavelength of the absorption spectrum specific to the gas being defined as the center and more preferably a wavelength region in a range from 3 µm to 5 µm.

The method of calibrating an infrared photodetector according to the present invention should only calibrate the infrared photodetector by applying a voltage at an offset value to the infrared photodetector in which the active layer contains a quantum well or quantum dots, and it does not necessarily have to include the step of determining a voltage at the offset value from the reference wavelength. An amount of deviation may be measured (specified) in advance for each individual infrared photodetector having a manufacturing variation and calibration may be performed by applying the voltage at the offset value to the infrared photodetector.

Suitable examples of the detector according to the present invention include infrared photodetectors making use of intersubband transition such as a quantum dot infrared photodetector (QDIP) in which an active layer contains quantum dots and a quantum well infrared photodetector (QWIP) in which an active layer contains a quantum well. These infrared photodetectors are characterized in having a relatively narrow detection spectrum line width and being capable of shifting a position of a detection peak by applying a voltage. On the other hand, these infrared photodetectors are varied in detection spectrum as shown in Fig. 1A due to a size and a density of quantum dots and a manufacturing error in a quantum structure such as a quantum well as described above. In the example described above, any absorption peak wavelength of an absorption spectrum specific to a gas corresponds to the "reference wavelength" to be referred to as the criterion for calibration or correction of the detection wavelength.

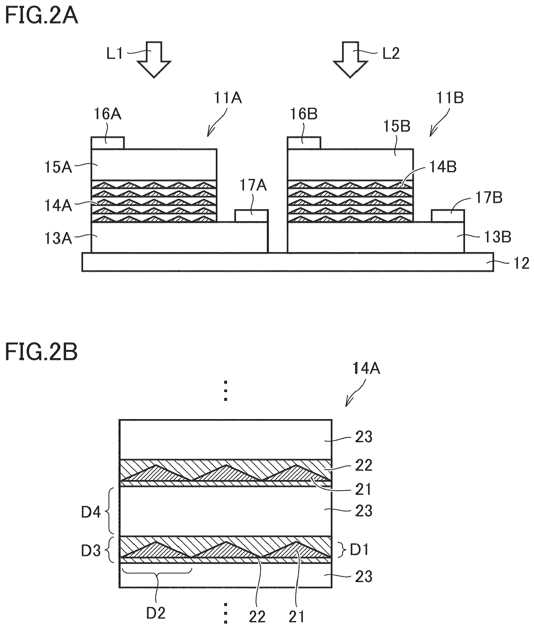

Figs. 2A and 2B are diagrams schematically showing infrared photodetectors 11A and 11B representing preferred examples of the present invention. For example, Fig. 2A shows an example in which a quantum dot infrared photodetector 11A constituted of a lower contact layer 13A composed of n-GaAs, an upper contact layer 15A composed of n-GaAs, electrodes 16A and 17A composed of AuGe/Ni/Au, and an InAs quantum dot/AlGaAs (AlₓGa₁₋ₓAs (0 < x < 1.0))/GaAs (n-GaAs) matrix 14A and a quantum dot infrared photodetector 11B constituted of a lower contact layer 13B composed of n-GaAs, an upper contact layer 15B composed of n-GaAs, electrodes 16B and 17B composed of AuGe/Ni/Au, and an InAs quantum dot/AlGaAs (AlₓGa₁₋ₓAs (0 < x < 1.0))/GaAs (n-GaAs) matrix 14B are formed on a substrate 12 composed of semi-insulating GaAs.

Fig. 2B is a partially enlarged view of InAs quantum dot/AlGaAs/GaAs matrix 14A in Fig. 2A. Fig. 2B illustrates an example where an infrared photodetector having a detection peak in the vicinity of 4 µm is implemented, and for example, an InAs quantum dot 21 has a height D1 of 5 nm and a length D2 of a bottom of a pyramidal shape of 25 nm. In the example shown in Fig. 2B, such InAs quantum dot 21 is surrounded by an AlGaAs layer 22, and for example, thirty InAs quantum dot/AlGaAs layers are successively stacked with a GaAs layer 23 being interposed so that InAs quantum dot/AlGaAs/GaAs matrix 14A is formed. AlGaAs layer 22 has a thickness D3 of 10 nm and covers quantum dot 21 from the top and the bottom thereof by a thickness of 2.5 nm (that is, 2.5 nm (a thickness of a portion covering the top of quantum dot 21) + 5 nm (height D1 of quantum dot 21) + 2.5 nm (a thickness of a portion covering the bottom of quantum dot 21) = 10 nm (thickness D3 of AlGaAs layer 22)). In the example shown in Fig. 2B, GaAs layer 23 has a thickness D4 of 30 nm.

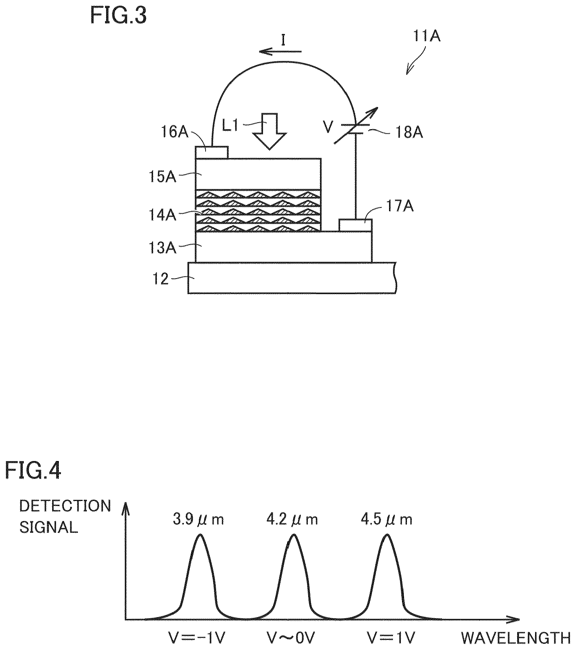

Fig. 3 is a diagram schematically showing electrodes 16A and 17A of infrared photodetector 11A shown in Fig. 2A being electrically connected to a power supply 18A. As shown in Fig. 3, when voltage V is applied to electrodes 16A and 17A by power supply 18A, a current I flows in infrared photodetector 11A. When infrared rays L1 corresponding to the detection wavelength of infrared photodetector 11A are externally irradiated, the current increases as compared with an example without irradiation of infrared rays L1 and becomes a detection signal. This increment is herein called a "photocurrent".

Fig. 4 shows a detection spectrum schematically showing a detection peak when various voltages are applied to infrared photodetector 11A shown in Fig. 3. In Fig. 4, the ordinate represents a detection signal and the abscissa represents a wavelength (a unit of µm). As shown in Fig. 4, a detection spectrum which has a detection peak at a specific wavelength (a wavelength detected at a median which is substantially at the center in a range of applied voltages; for example, 4.2 µm in the vicinity of V ∼ 0 V (strictly speaking, not 0 V)) appears. This is because infrared rays cause inter-sublevel absorption of quantum dots and photoelectric conversion is brought about. When a value of voltage V applied to infrared photodetector 11A is varied, energy state of electrons is varied and hence a position of the detection peak is shifted. For example, in the infrared photodetector of which detection peak in the vicinity of V ∼ 0 V is exhibited at 4.2 µm as shown in Fig. 4, when V = 1 V is set, a detection peak is exhibited at 4.5 µm, and when V = -1 V is set, a detection peak is exhibited at 3.9 µm. Shift by ±0.3 µm can thus be achieved.

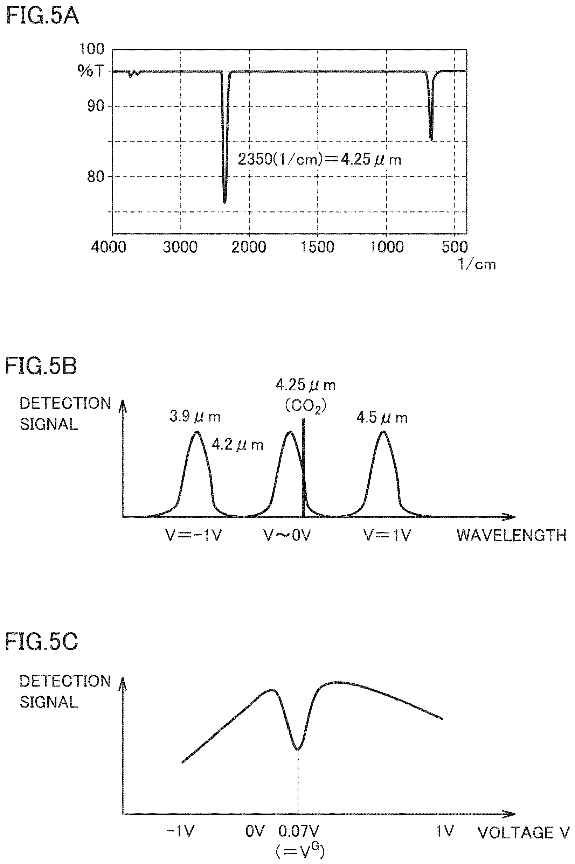

Fig. 5A shows an infrared transmission spectrum of carbon dioxide, Fig. 5B is a diagram showing the detection spectrum shown in Fig. 4 on which an absorption peak wavelength of carbon dioxide (CO₂) is superimposed, and Fig. 5C shows a graph of a result of detection of a signal (a detection signal) of outside light (solar rays) while a value of voltage V applied to infrared photodetector 11A is varied. In Fig. 5C, the ordinate represents a detection signal and the abscissa represents a voltage (a unit of V). As shown in Fig. 5A, carbon dioxide strongly absorbs 2350 (l/cm) = 4.25 µm. When the absorption peak wavelength of carbon dioxide (CO₂) is superimposed on the detection spectrum shown in Fig. 4, the absorption peak wavelength of carbon dioxide is present between the detection peak at a voltage from V ∼ 0 V and the detection peak at a voltage of V = 1 V as shown in Fig. 5B. Therefore, detection of a signal (a detection signal) of outside light (solar rays) while a value of voltage V applied to the infrared photodetector is varied is as shown in Fig. 5C. Lowering is seen at V = 0.07 V where the detection signal from infrared photodetector 11A (an integral of the detection spectrum) matches with absorption by carbon dioxide. This is because light at 4.25 µm is absorbed by carbon dioxide before it reaches the infrared photodetector. A value of voltage V which matches with the absorption peak wavelength of carbon dioxide (0.07 V in the example shown in Fig. 5C) is denoted as V^{G}.

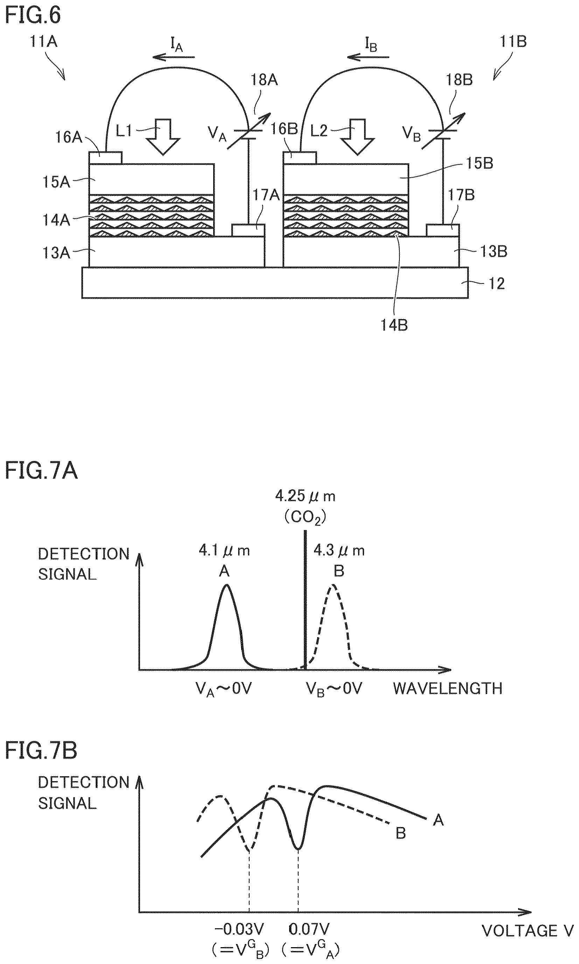

Fig. 6 is a diagram schematically showing electrodes 16A and 17A of infrared photodetector 11A shown in Fig. 2A being electrically connected to power supply 18A and electrodes 16B and 17B of infrared photodetector 11B being electrically connected to a power supply 18B. Fig. 7A is a diagram of a detection spectrum exhibiting each detection peak while no voltage is applied in infrared photodetectors 11A and 11B shown in Fig. 6 (V_{A} ∼ 0 V and V_{B} ∼ 0 V) on which an absorption peak wavelength of carbon dioxide (CO₂) is superimposed, and Fig. 7B shows a graph of a result of detection of a signal (a detection signal) of outside light (solar rays) while voltage values V_{A} and V_{B} applied to infrared photodetectors 11A and 11B are varied. In an infrared photodetector array in which two infrared photodetectors 11A and 11B are integrated on one substrate 12 as shown in Fig. 2A, for example, as shown in Fig. 7A, infrared photodetector 11A has a detection peak at 4.1 µm and infrared photodetector 11B has a detection peak at 4.3 µm under the influence by a manufacturing error. When outside light (solar rays) is detected while value V_{A} and value V_{B} of voltages applied to respective infrared photodetector 11A and infrared photodetector 11B are varied, detection signals as shown in Fig. 7B are obtained. In infrared photodetector 11A, lowering in detection signal due to absorption by carbon dioxide at 0.07 V (= V^{G}A) is observed, whereas in infrared photodetector 11B, lowering in detection signal due to absorption by carbon dioxide at -0.03 V (= V^{G}B) is observed. When reference voltages for the values of voltages V applied to infrared photodetectors 11A and 11B are denoted as V^{G}A and V^{G}B, respectively and voltages applied to infrared photodetectors 11A and 11B are defined as differences from V^{G}A and V^{G}B (ΔVA and ΔVB), detection peak wavelengths of infrared photodetectors 11A and 11B substantially match with each other when a condition of ΔVA = ΔVB is satisfied. This means that V^{G}A and V^{G}B are set to prescribed values (offset values) and sweeping of a voltage applied to infrared photodetectors 11A and 11B while these prescribed values (offset values) are applied corresponds to sweeping of ΔVA and ΔVB.

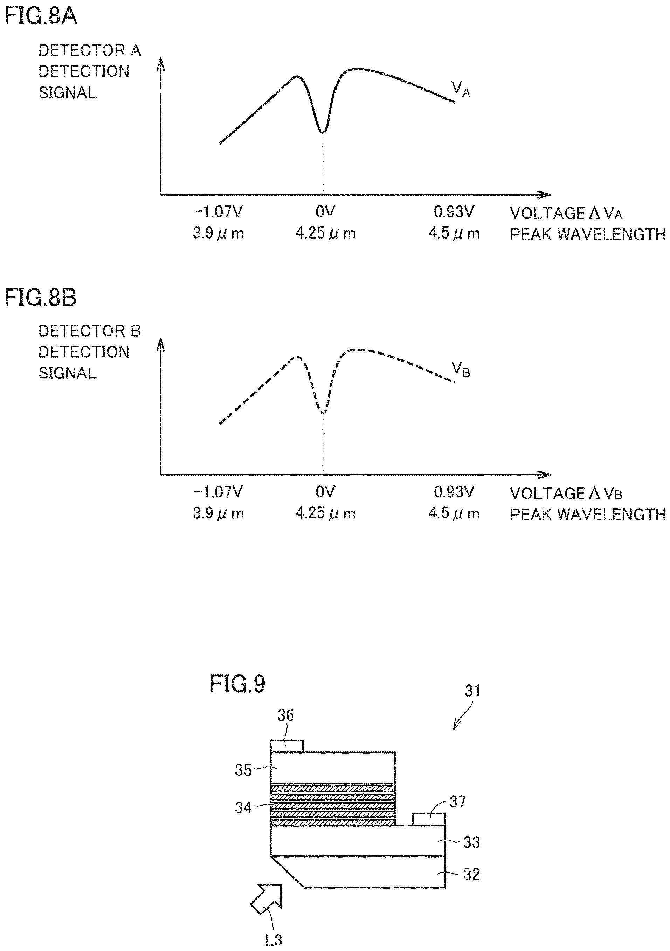

Figs. 8A and 8B show detection spectra of infrared photodetectors 11A and 11B when solar rays are detected. In Fig. 8A, the ordinate represents a detection signal from infrared photodetector 11A and the abscissa represents a value of a differential voltage (ΔV_{A}) from V^{G}_{A}, and in Fig. 8B, the ordinate represents a detection signal from infrared photodetector 11B and the abscissa represents a value of a differential voltage (ΔV_{B}) from V^{G}_{B}. As can be seen in Figs. 8A and 8B, with V^{G}A and V^{G}B being defined as the reference voltages, a difference in detection peak due to a manufacturing error of infrared photodetector 11A and infrared photodetector 11B can be compensated for in a simplified manner by shifting a position of a detection peak by applying a voltage. In the method of calibrating an infrared photodetector according to the present invention, preferably, variation in detection peak in an individual infrared photodetector is corrected by setting an absorption peak wavelength of an absorption spectrum specific to a gas as a reference voltage of the voltage applied to the infrared photodetector. Here, by shifting the position of the detection peak by applying a voltage to the infrared photodetector with a difference from the reference voltage being defined as the voltage value, variation in detection peak in a direction of wavelength in application of the voltage can be prevented. Preferably, variation in sensitivity of each infrared photodetector is detected from the detection signal when the reference voltage is set and signal processing for compensating for variation in sensitivity of each infrared photodetector is performed. By doing so, when a plurality of detectors detect different wavelengths and compare the wavelengths or when the detectors are arrayed for imaging, production of an error in a result of measurement provided to a user due to variation in detection wavelength can be prevented.

Though two integrated infrared photodetectors 11A and 11B are illustrated as the detector according to the present invention, three or more infrared photodetectors may be integrated and a method of calibrating an infrared photodetector according to the present invention may be applied for the purpose of matching detection wavelengths of a plurality of infrared photodetectors which are not integrated. A detection device including a plurality of detectors according to the present invention described above, the detectors being identical in reference wavelength, may be applicable. According to such a detection device according to the present invention, variation in manufacturing of a detection device can efficiently be calibrated or corrected in a simplified manner and production of an error in a result of measurement provided to a user can be prevented.

Though an infrared photodetector including a device structure containing GaAs, InAs, and AlGaAs (AlGaInAs) has been described by way of example in the example above, the detector according to the present invention may be based on other materials such as other semiconductors such as Si, Ge, AlGaInP, or AlInGaN, and a quantum dot structure can also be selected as appropriate based on combination with the materials.

Though a wavelength band of the infrared photodetector has been described with criterion to infrared rays in the vicinity of 4.25 µm, for example, wavelengths from 8 to 12 µm representing an atmospheric window or a terahertz band may be applicable. By using interband absorption instead of intersubband absorption, a detector in a wavelength band of a visible range or an ultraviolet range is obtained.

Though exemplary use of 4.25 µm representing one of absorption peaks of carbon dioxide has been described above by way of example of a wavelength used for calibration, other absorption peaks of carbon dioxide may be used as a reference wavelength to be referred to as the criterion for calibration or correction of the detector according to the present invention. An absorption peak of water vapor of which aggregate of fine peaks is present in the vicinity of a wavelength of 1700 (1/cm) = 5.88 µm and 1550 (1/cm) = 6.55 µm may be made use of. In addition, any absorption spectrum of a gas of which absorption spectrum specific thereto has already been known, such as an absorption spectrum of nitrogen oxide (NOₓ), sulfur oxide (SOₓ), or ammonia (NH₃), may be used. From a point of view of application of the method of calibrating an infrared photodetector according to the present invention with a simplified configuration, however, an absorption peak associated with a gas contained in air is preferably used.

In the present invention, the reference wavelength is not limited to an absorption peak wavelength of an absorption spectrum specific to a gas described above so long as it is within a wavelength region in which a detection wavelength can be shifted. In the present invention, a wavelength at an end of the atmospheric window, that is, a wavelength at a boundary (a rising edge or a falling edge) beyond which a wavelength is out of the atmospheric window, may also be handled as the criterion for calibration or correction of a detection wavelength. The reference wavelength in the present invention is preferably set to a wavelength at which a detection value from the detector exhibits a relative maximum value, a relative minimum value, a rising edge, or a falling edge, and the absorption peak wavelength of the absorption spectrum specific to the gas described above represents one of the reference wavelengths at which the detection value from the detector exhibits the relative minimum value. An absorption wavelength of an optical element is given as an exemplary reference wavelength at which a detection value from another detector exhibits the relative minimum value. Examples of reference wavelengths at which a detection value from the detector exhibits the relative maximum value include an emission wavelength, a phosphorescence wavelength, and a fluorescence wavelength. A detector integrated with a light emitting element would also be able to calibrate or correct a detection wavelength with an emission wavelength of the light emitting element. Thus, when the reference wavelength is set to a wavelength at which a detection value from the detector exhibits the relative maximum value, the relative minimum value, the rising edge, or the falling edge, the detector according to the present invention is preferably configured to calibrate or correct the detection wavelength with a value of a voltage applied to the active layer when the detection value from the detector exhibits the relative maximum value, the relative minimum value, the rising edge, or the falling edge.

Fig. 9 is a diagram schematically showing an infrared photodetector 31 in another preferred example of the present invention. Infrared photodetector 31 in the example shown in Fig. 9 is a quantum well infrared photodetector (QWIP) including a substrate 32 composed of semi-insulating GaAs (i-GaAs), a lower contact layer 33 composed of n-GaAs, an upper contact layer 35 composed of n-GaAs, electrodes 36 and 37 composed of AuGe/Ni/Au, and an active layer 34 composed of a GaAs quantum well and an AlₓGa₁₋ₓAs barrier. Active layer 34 in infrared photodetector 31 in the example shown in Fig. 9 is configured to include thirty cycles of the GaAs quantum well having a thickness of 8 nm and the AlₓGa₁₋ₓAs barrier having a thickness of 15 nm. Infrared photodetector 31 in the example shown in Fig. 9 is configured such that an end surface of substrate 32 is polished at 45 degrees and infrared rays L3 can be incident from the end surface polished at 45 degrees. The method of calibrating an infrared photodetector according to the present invention can suitably be applied not only to the quantum dot infrared photodetector (QDIP) in which the active layer contains quantum dots as described above but also to the quantum well infrared photodetector (QWIP) in which the active layer contains the quantum well as shown in Fig. 9.

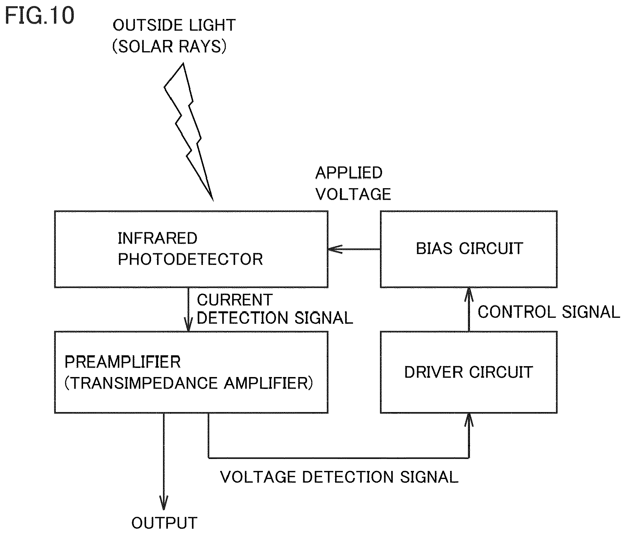

Fig. 10 shows one exemplary block diagram of the infrared photodetector according to the present invention. Fig. 10 shows an example in which calibration is performed by using outside light (solar rays) and the infrared photodetector is electrically connected to a preamplifier (a transimpedance amplifier) such that a current detection signal can be fed, and the preamplifier is configured to be able to provide an output and electrically connected to a driver circuit so as to output a voltage detection signal. In the example shown in Fig. 10, the driver circuit is electrically connected to a bias circuit so as to be able to feed a control signal, and the bias circuit is electrically connected to the infrared photodetector so as to be able to apply a bias voltage (an application voltage).

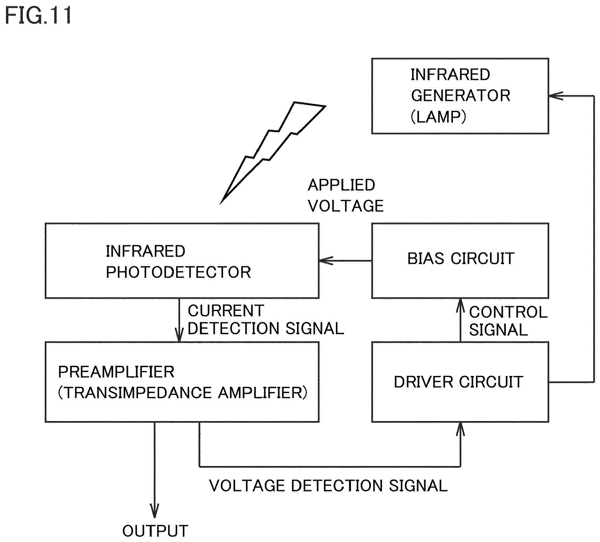

Fig. 11 shows another exemplary block diagram of the infrared photodetector according to the present invention. Fig. 11 shows an example configured to perform calibration with an infrared generator (lamp) provided in an apparatus, instead of outside light (solar rays). The example shown Fig. 11 is similar to the block diagram shown in Fig. 10 except that the infrared generator (lamp) electrically connected to the driver circuit is further provided and configured to be able to emit light to the infrared photodetector.

Though Figs. 10 and 11 show only a single infrared photodetector, the driver circuit and the preamplifier can also be used in common in an example of an infrared photodetector array in which a plurality of infrared photodetectors are integrated.

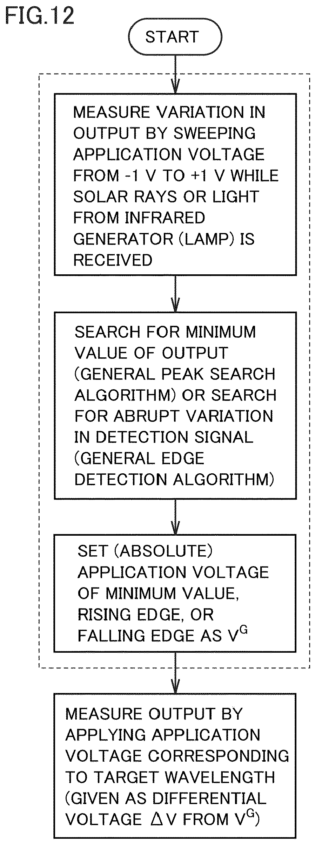

Fig. 12 is a flowchart showing exemplary control of the infrared photodetector in Embodiment 1. For example, steps (1) to (4) below are performed for each element.
(1) Variation in output is measured by sweeping a bias voltage (an application voltage) from -1 V to +1 V while outside light (solar rays) or light from the infrared generator (lamp) is received (though a range of sweeping is set to a range from -1 V to +1 V, it is merely by way of example and another range may be used).
(2) A minimum value of an output is searched for (a general peak search algorithm) (the minimum value may be a relative minimum value) or abrupt variation in detection signal is searched for (a general edge detection algorithm).
(3) An (absolute) application voltage of a minimum value, a rising edge, or a falling edge is set as V^{G}.
(4) An output is measured by applying an application voltage corresponding to a target wavelength (given as a differential voltage ΔV from V^{G}).

The steps (1) to (3) may be performed each time calibration is performed or may be performed only once in an initial stage.

As described above, preferably, the method of calibrating an infrared photodetector according to the present invention includes the step of applying a voltage at an offset value to the infrared photodetector in which the active layer contains a quantum well or quantum dots. For example, the configuration may be such that a voltage at an offset value appropriate for calibration is measured before shipment of a product, the voltage at the offset value is stored, and the voltage at the stored offset value is applied in use. Even in the configuration as in the example described above, instead of measurement of a detection peak wavelength at each time of use, the configuration may be such that a voltage at an offset value appropriate for calibration is measured before shipment of a product and the voltage at the offset value is applied in use. The infrared photodetector may be configured such that a calibration attachment is attachable. Namely, the configuration may be such that a voltage value at an offset value appropriate for calibration can be updated by measuring a detection peak wavelength by attaching the calibration attachment, although the infrared photodetector is normally used without the calibration attachment being attached thereto.

### <Embodiment 2>

Embodiment 1 shows an example in which a detection peak is exhibited at 4.2 µm in the vicinity of V ∼ 0 V. Therefore, voltage V^{G} at which an absorption peak wavelength of CO₂ appears can be handled as a voltage at the offset value (V^{OFF}) (that is, V^{OFF} = V^{G}). Since detection sensitivity is high when a voltage high to some extent is applied, it may be difficult in the vicinity of V ∼ 0 V to distinguish a relative minimum value of the detection value based on an absorption spectrum specific to a gas. In the present embodiment, an example in which an absorption peak wavelength of an atmosphere is exhibited at a voltage value distant from V ∼ 0 V is described. Being distant from 0 V should only be that there is a difference from 0 V not less than a resolution of an application voltage of an apparatus.

In this case, a design value of an application voltage V0 for detecting an absorption peak wavelength of a gas to be referred to should only be stored. Then, a voltage at a prescribed value (an offset value) should only be set to V^{OFF} = V^{G}-V0 and calibration should only be performed with the method the same as in Embodiment 1.

Thus, the detector according to the present invention may be configured such that a wavelength at which a detection value from the detector exhibits the relative maximum value or the relative minimum value when a value of a voltage applied to the active layer is in a range from V to V0 is defined as the reference wavelength and a difference between a value of voltage V^{G} applied to the active layer at the time when the reference wavelength is set and V0 is defined as an offset voltage.

### <Embodiment 3>

In the present embodiment, criterion not only to a single detection wavelength but also to a plurality of detection wavelengths will be described. An example in which two wavelengths λ1 and λ2 are referred to will be described by way of example below.

When design values of application voltages corresponding to λ1 and λ2 have been known, V1^{OFF} found by referring to λ1 and V2^{OFF} found by referring to λ2 are calculated. An average value of V1^{OFF} and V2^{OFF}, however, may be applied as V^{OFF} to all wavelengths, or relation between the wavelength and the offset voltage may linearly be approximated from λ1 and V1^{OFF} and λ2 and V2^{OFF}.

Thus, the detector according to the present invention may be configured to calibrate or correct a detection wavelength with a plurality of reference wavelengths. In this case, the detector may be configured to define a wavelength detected when a value of a voltage applied to the active layer is set to a value other than V ∼ 0 V as one of the reference wavelengths.

In the present embodiment, a detection wavelength can be calibrated without storing a design value of the application voltage as in Embodiment 2 described above. A relative minimum value smaller in application voltage value among relative minimum values searched for in the step (2) in the flowchart shown in Fig. 12 should only be set as a shorter reference wavelength, a relative minimum value greater in application voltage value should only be set as a longer reference wavelength, and relation between the wavelength and the application voltage should only linearly be approximated from λ1 and V1^{G} and λ2 and V2^{G}.

A wavelength at which a transmittance is abruptly varied at the end of the atmospheric window, that is, exhibits the rising edge or the falling edge, may be employed for λ1 and λ2.

### <Embodiment 4>

In the present embodiment, instead of calibrating the infrared photodetector with a prescribed value (an offset value), a result of detection by the infrared photodetector is corrected with the offset value. In the embodiment described above, "calibration" in which a detection wavelength is measured while a voltage referred to with the reference wavelength being defined as the reference voltage is applied has mainly been described by way of example, however, "correction" in which a voltage referred to with the reference wavelength being defined as the reference voltage is subtracted from a voltage value in a result of measurement may be performed. The present invention encompasses not only the method of calibrating a detector but also a method of correcting a detector.

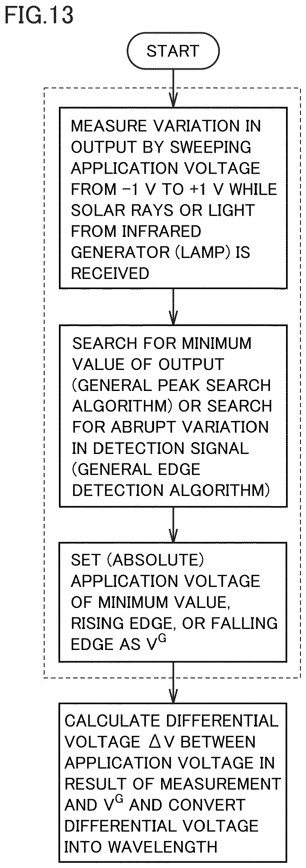

Fig. 13 is a flowchart showing exemplary control of the infrared photodetector in Embodiment 4. For example, steps (1) to (4) below are performed for each element.
(1) Variation in output is measured by sweeping an application voltage from -1 V to +1 V while outside light (solar rays) or light from the infrared generator (lamp) is received.
(2) A minimum value of an output is searched for (a general peak search algorithm) (the minimum value may be a relative minimum value) or abrupt variation in detection signal is searched for (a general edge detection algorithm).
(3) An (absolute) application voltage of a minimum value, a rising edge, or a falling edge is set as V^{G}.
(4) Differential voltage ΔV between the application voltage in the result of measurement and V^{G} is calculated and converted into a wavelength.

The flowchart shown in Fig. 13 is different from the flowchart shown in Fig. 12 in step (4). Instead of measurement by application of an application voltage while V^{G} is provided as the offset value, the value of the application voltage in the result of measurement in (1) is corrected with V^{G}.

In particular, when infrared photodetectors are arrayed, correction of data after measurement is advantageously simpler rather than setting of an offset value for an individual element.

The correction method described in the present embodiment can also be used in the configuration in which a median in a range of application voltages is set as V^{G} in Embodiment 1, the configuration in which V^{G} is distant from 0 V in Embodiment 2, and the configuration in which two reference wavelengths are referred to in Embodiment 3.

### <Embodiment 5>

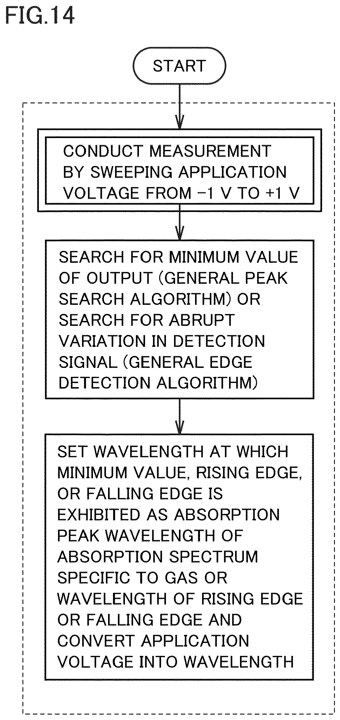

In the present embodiment, a result of measurement is corrected without determining application voltage V^{G} or V^{OFF}. Fig. 14 is a flowchart showing exemplary control of the infrared photodetector in Embodiment 5. For example, steps (1) to (3) below are performed for each element.
(1) Measurement is conducted by sweeping an application voltage from -1 V to +1 V.
(2) A minimum value of an output is searched for (a general peak search algorithm) (the minimum value may be a relative minimum value) or abrupt variation in detection signal is searched for (a general edge detection algorithm).
(3) An application voltage is converted to a wavelength such that a wavelength at which the minimum value, the rising edge, or the falling edge is exhibited matches with an absorption peak wavelength of an absorption spectrum specific to a gas or a wavelength of the rising edge or the falling edge. This is equivalent to application of an offset value in converting an application voltage into a wavelength.

In the flowchart shown in Fig. 14, the step of determining application voltage V^{G} or V^{OFF} is not provided but the voltage is converted as it is to a wavelength. By doing so, advantageously, the number of steps is smaller, it is not necessary to hold (store) V^{G}, V0, or V^{OFF}, and simplification is achieved.

The correction method described in the present embodiment can also be used in the configuration in which the reference wavelength corresponds to a median in a range of application voltages in Embodiment 1, the configuration in which the reference wavelength corresponds to a voltage value distant from the application voltage of 0 V in Embodiment 2, and the configuration in which two reference wavelengths are referred to in Embodiment 3.

### <Embodiment 6>

The detector according to the present invention may further include a substrate and the reference wavelength may be a wavelength at which a transmittance of the substrate exhibits the relative maximum value, the relative minimum value, the rising edge, or the falling edge. The present invention also provides a detector which includes a substrate and a photoelectric conversion unit containing a quantum well or quantum dots, the detector being capable of shifting a detection wavelength by applying a voltage to the photoelectric conversion unit, the detector having a wavelength to be referred to as a criterion for calibration or correction of the detection wavelength within a wavelength region in which the detection wavelength can be shifted, the wavelength to be referred to as the criterion being a wavelength at which the transmittance of the substrate exhibits the relative maximum value, the relative minimum value, the rising edge, or the falling edge. The detector according to the present invention is preferably configured to calibrate or correct the detection wavelength with the wavelength at which the transmittance of the substrate exhibits the relative maximum value, the relative minimum value, the rising edge, or the falling edge being defined as the criterion.

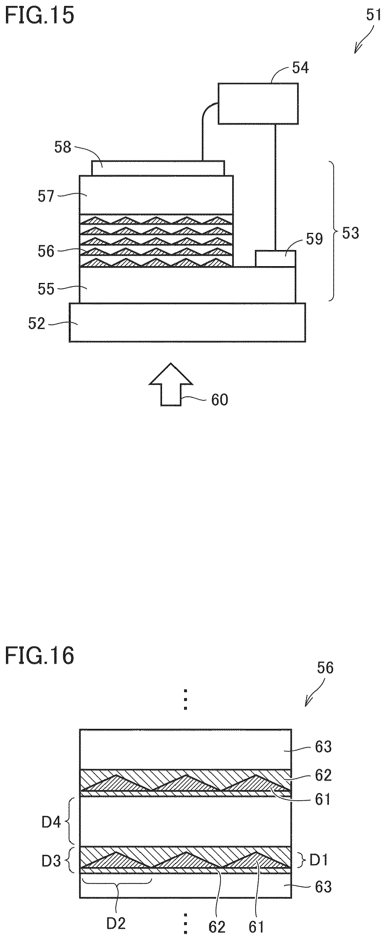

Fig. 15 is a diagram schematically showing an infrared photodetector 51 in Embodiment 6. For example, Fig. 15 shows a quantum dot infrared photodetector 51 including on a substrate 52, a photoelectric conversion unit 53 configured such that a lower contact layer 55, an InₓGa₁₋ₓAs quantum dot (0 ≤ x ≤ 1)/In_{y}Ga_{1-y}As (0 ≤ y < 1)/Al_{z}Ga_{1-z}As (0 ≤ z ≤ 1) matrix (active layer) 56, and an upper contact layer 57 are stacked in this order with a buffer layer (not shown) being interposed, as well as an operation unit and a detection unit (shown as an operation unit/detection unit 54 in Fig. 15) electrically connected to electrodes 58 and 59 formed in upper contact layer 57 and lower contact layer 55, respectively. Infrared photodetector 51 in the example shown in Fig. 15 is configured, for example, such that outside light (solar rays) 60 is incident from a side of substrate 52.

In the detector according to the present invention, substrate 52 is composed, for example, of silicon. A silicon substrate is inexpensive and commonly used, achieves absorption around a wavelength of 9 µm, and is suitable for detection of a band from 8 to 14 µm representing the atmospheric window. Though such a silicon substrate can suitably be implemented by a low-cost silicon substrate fabricated with a Czochralski (CZ) method representing a general manufacturing method, it may naturally be obtained with a different manufacturing method. The silicon substrate may be an on-axis Silicon substrate of which off angle is 0 degree, which is particularly suitable for a large-scale image sensor.

In the detector according to the present invention, photoelectric conversion unit 53 should only include a wavelength around 9 µm described above in its absorption range and a wavelength should only be operated within the range of absorption wavelengths through an external operation. In infrared photodetector 51 in the example shown in Fig. 15, lower contact layer 55 and upper contact layer 57 are composed, for example, of n-GaAs, and electrodes 58 and 59 are composed, for example, of AuGeNi/Au. The buffer layer may be composed mainly of GaAs, and may include a nucleation layer composed of AlGaAs or AlAs or a strained superlattice layer composed of InGaAs/GaAs or InAlAs/GaAs. In the detector according to the present invention, the operation unit should only be configured to be operable such that a voltage can be applied to photoelectric conversion unit 53 by an external circuit. In the detector according to the present invention, the detection unit should only be configured to be able to detect a signal obtained from photoelectric conversion unit 53 with an external circuit, and may be integrated with an operation unit like operation unit/detection unit 54 shown in Fig. 15.

Infrared photodetector 51 in the example shown in Fig. 15 may be obtained by directly growing a quantum dot structure on silicon substrate 52 or bonding a quantum dot structure on a GaAs substrate to the silicon substrate through wafer bonding.

Fig. 16 is a partially enlarged view of InAs quantum dot/AlGaAs/GaAs matrix 56 in Fig. 15. Fig. 16 illustrates an example in which an infrared photodetector having a detection peak in the vicinity of 9 µm is implemented. For example, an InAs quantum dot 61 has a height D1 of 5 nm and a length D2 of a bottom of a pyramidal shape of 25 nm. In the example shown in Fig. 16, such InAs quantum dot 61 is surrounded by an InGaAs layer 62, and for example, thirty InAs quantum dot/InGaAs layers are successively stacked with a GaAs layer 63 being interposed so that an InₓGa₁₋ₓAs quantum dot (0 ≤ x ≤ 1)/In_{y}Ga_{1-y}As (0 ≤ y < 1)/Al_{z}Ga_{1-z}As (0 ≤ z ≤ 1) matrix 56 is formed. InGaAs layer 62 has a thickness D3 of 10 nm, and covers quantum dot 61 from the top and the bottom thereof by a thickness of 2.5 nm in InGaAs layer 62 (that is, 2.5 nm (a thickness of a portion covering the top of quantum dot 61) + 5 nm (height D1 of quantum dot 61) + 2.5 nm (a thickness of a portion covering the bottom of quantum dot 61) = 10 nm (thickness D3 of InGaAs layer 62)). In the example shown in Fig. 16, GaAs layer 63 has a thickness D4 of 40 nm.

Though a device structure containing GaAs, InAs, and InGaAs has been described in the example shown in Fig. 16, a base by other materials such as other semiconductors such as AlGaAs, InGaP, InAlAs, AlGaAsSb, AlGaInP, or InAlGaAs may be applicable, and a quantum dot structure can also be selected as appropriate based on combination with the materials. For example, such an active layer that a portion surrounding an InAs quantum dot is composed of GaAs and InAs/GaAs is isolated by AlGaAs may be applicable.

In the present invention, as described above, a photoelectric conversion unit may integrally be formed on a substrate to be referred to as the criterion for calibration or correction of a detection wavelength, however, the substrate to be referred to as the criterion for calibration or correction of the detection wavelength may be provided separately from the photoelectric conversion unit. The detector according to the present invention may be a detector which separately includes a substrate to be referred to as the criterion for calibration or correction of a detection wavelength and a photoelectric conversion unit formed on a substrate which is not the substrate to be referred to as the criterion for calibration or correction of a detection wavelength. For example, a photoelectric conversion unit is formed on a GaAs substrate and a silicon substrate to be referred to as the criterion for calibration or correction of a detection wavelength may separately be provided on a side where outside light is incident. The substrate may be an optical element such as a lens. For example, a wavelength filter may be applicable, and in that case, a wavelength at which a transmittance is abruptly varied, that is, a rising edge or a falling edge is exhibited, due to abrupt variation in absorption or reflectance by the wavelength filter may be defined as the criterion for calibration or correction.

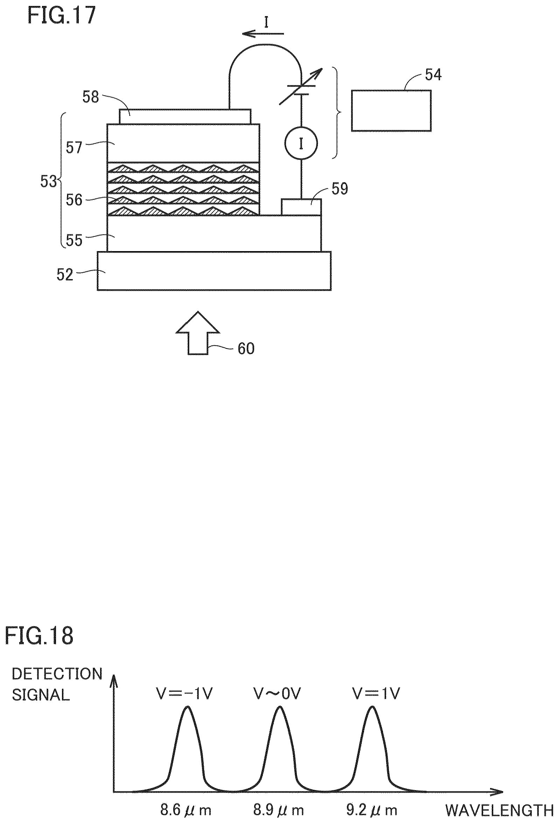

Fig. 17 is a diagram schematically showing electrodes 58 and 59 of infrared photodetector 51 shown in Fig. 15 being electrically connected to a power supply. As shown in Fig. 17, when the power supply applies voltage V to electrodes 58 and 59 in response to an operation onto the operation unit, current I flows in infrared photodetector 51. The detection unit detects this current I. When infrared rays corresponding to a detection wavelength of infrared photodetector 51 are externally irradiated, the current increases as compared with an example without irradiation of infrared rays to become a detection signal. This increment is called a "photocurrent" as described above.

Fig. 18 shows a detection spectrum schematically showing a detection peak when various voltages are applied to infrared photodetector 51 shown in Fig. 17. In Fig. 18, the ordinate represents a detection signal and the abscissa represents a wavelength (a unit of µm). As shown in Fig. 18, a detection spectrum which has a detection peak at a specific wavelength (a wavelength detected at a median which is substantially at the center in a range of applied voltages; for example, 8.9 µm in the vicinity of V ∼ 0 V (strictly speaking, not 0 V)) appears. This is because infrared rays cause inter-sublevel absorption of quantum dots and photoelectric conversion is brought about. When a value of voltage V applied to infrared photodetector 51 is varied, energy state of electrons is varied and a position of the detection peak is shifted. For example, in the infrared photodetector of which detection peak in the vicinity of V ∼ 0 V is exhibited at 8.9 µm as shown in Fig. 18, when V = 1 V is set, a detection peak is exhibited at 9.2 µm, and when V = -1 V is set, the detection peak is exhibited at 8.6 µm. Shift by ±0.3 µm can thus be achieved. When the configuration is such that the median substantially at the center of a range of applied voltages is defined as an absorption peak wavelength of the substrate as in the present embodiment, the possibility that a peak which is referred to is out of the range of application voltages due to variation for each element is low.

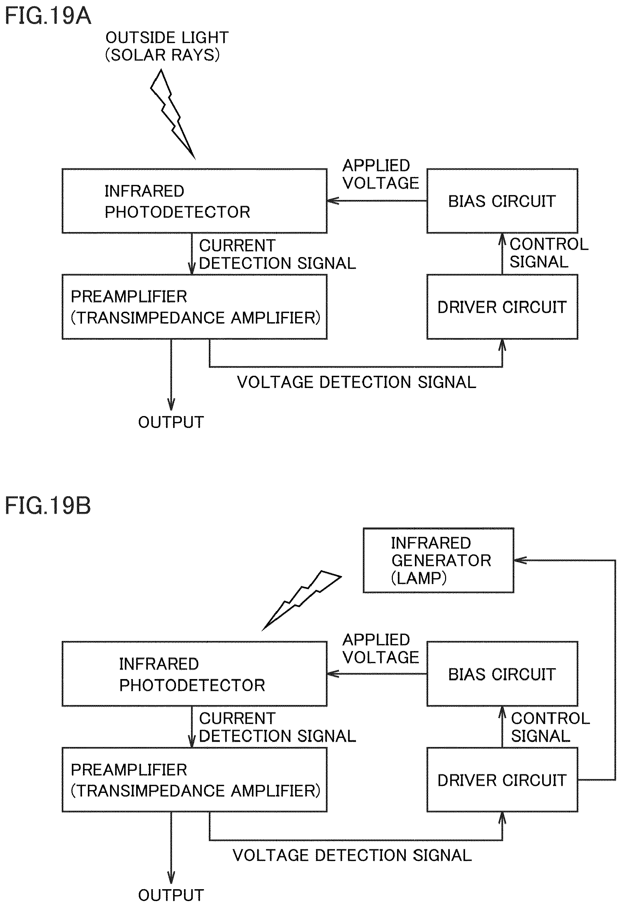

Fig. 19A shows one exemplary block diagram of the infrared photodetector in Embodiment 6. Fig. 19A shows calibration with outside light (solar rays) in which the infrared photodetector is electrically connected to a preamplifier (a transimpedance amplifier) such that a current detection signal can be fed and the preamplifier is configured to be able to provide an output and electrically connected to a driver circuit so as to output a voltage detection signal. In the example shown in Fig. 19A, the driver circuit is electrically connected to a bias circuit so as to be able to feed a control signal and the bias circuit is electrically connected to the infrared photodetector so as to be able to apply a bias voltage (an application voltage). The preamplifier, the driver circuit, and the bias circuit correspond to operation unit/detection unit 54.

Fig. 19B shows another exemplary block diagram of the infrared photodetector according to the present invention. Fig. 19B shows an example configured to perform calibration with an infrared generator (lamp) provided in an apparatus instead of outside light (solar rays). The example shown Fig. 19B is similar to the block diagram shown in Fig. 19A except that an infrared generator (lamp) electrically connected to the driver circuit is further provided to be able to emit light to the infrared photodetector.

Though Figs. 19A and 19B show only a single infrared photodetector 51, a driver circuit and a preamplifier can also be used in common in an infrared photodetector array in which a plurality of infrared photodetectors are integrated.

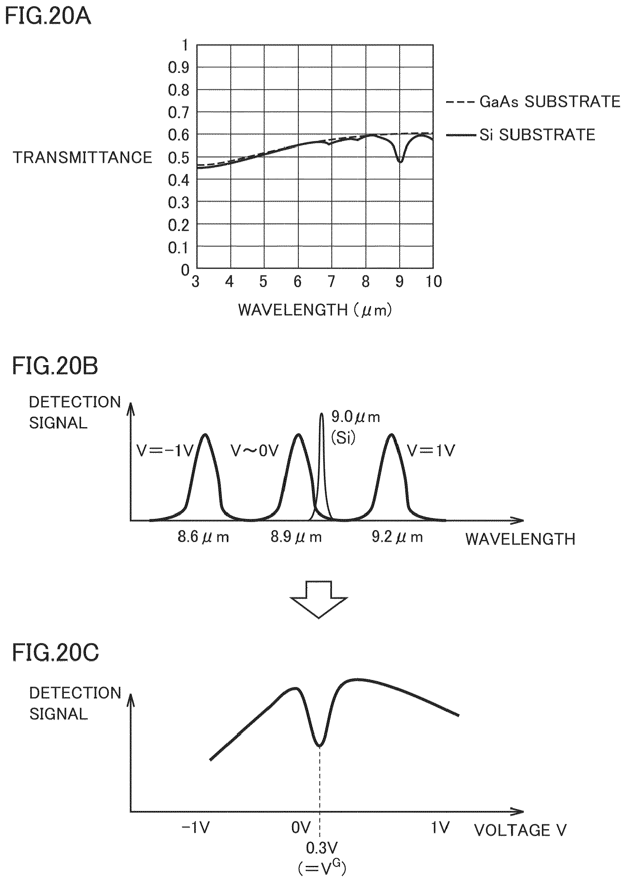

Fig. 20A shows infrared transmission spectra of a silicon substrate (a silicon (Si) substrate obtained with the CZ method representing a general manufacturing method) and a semi-insulating GaAs substrate, Fig. 20B is a diagram showing the detection spectrum shown in Fig. 18 on which an absorption peak wavelength of the silicon substrate is superimposed, and Fig. 20C shows a graph of a result of detection of a signal (a detection signal) of outside light (solar rays) while a value of voltage V applied to infrared photodetector 51 is varied. In Fig. 20A, the ordinate represents a transmittance and the abscissa represents a wavelength (µm). In Fig. 20C, the ordinate represents a detection signal and the abscissa represents a voltage (a unit of V). As shown in Fig. 20A, the silicon substrate strongly absorbs a wavelength of 9 µm. When the absorption peak wavelength of the silicon substrate is superimposed on the detection spectrum shown in Fig. 18, the absorption peak wavelength (9.0 µm) of the silicon substrate is present between the detection peak at a voltage of V ∼ 0 V and the detection peak at a voltage of V = 1 V as shown in Fig. 20B. Therefore, detection of a signal (a detection signal) of outside light (solar rays) while a value of voltage V applied to the infrared photodetector is varied is as shown in Fig. 20C. Lowering in detection signal in the photoelectric conversion unit is seen at V = 0.3 V where the detection peak wavelength matches with an absorption wavelength of silicon. This is because light at 9.0 µm is absorbed by the silicon substrate before it reaches the photoelectric conversion unit of the detector. A value of voltage V which matches with the absorption peak wavelength of silicon is denoted as V^{G}.

Thus, preferably, the detector according to the present invention is capable of shifting a detection wavelength by applying a voltage to the photoelectric conversion unit and includes a wavelength absorbed by the substrate within a wavelength region in which the detection wavelength can be shifted. Though a range of application voltages from -1 V to +1 V is shown by way of example, the range of application voltages is not limited to the range from -1 V to +1 V so long as the range includes a wavelength absorbed by the substrate.

A silicon (Si) substrate having a resistance value from 1 to 50 Ω·cm is used for measurement of an infrared transmission spectrum in Fig. 20A. When the silicon substrate has a resistance value not smaller than 5000 Ω·cm, there is substantially no absorption at 9.0 µm, whereas infrared rays are absorbed at 9.0 µm as the resistance value is smaller. The resistance value is desirably, for example, not greater than 1000 Ω·cm.

As described above, the detection spectrum of the detector in which the photoelectric conversion unit contains quantum dots is affected by a size or a density of quantum dots, and hence tends to be affected by a manufacturing error. Not only the manufacturing error of quantum dots but also a manufacturing error of an external circuit and variation over time in circuit constant also affect the detection spectrum. The infrared photodetector in Embodiment 6 described above is illustrated below as one exemplary detector according to the present invention, and calibration of the infrared photodetector (the method of calibrating an infrared photodetector) will be described.

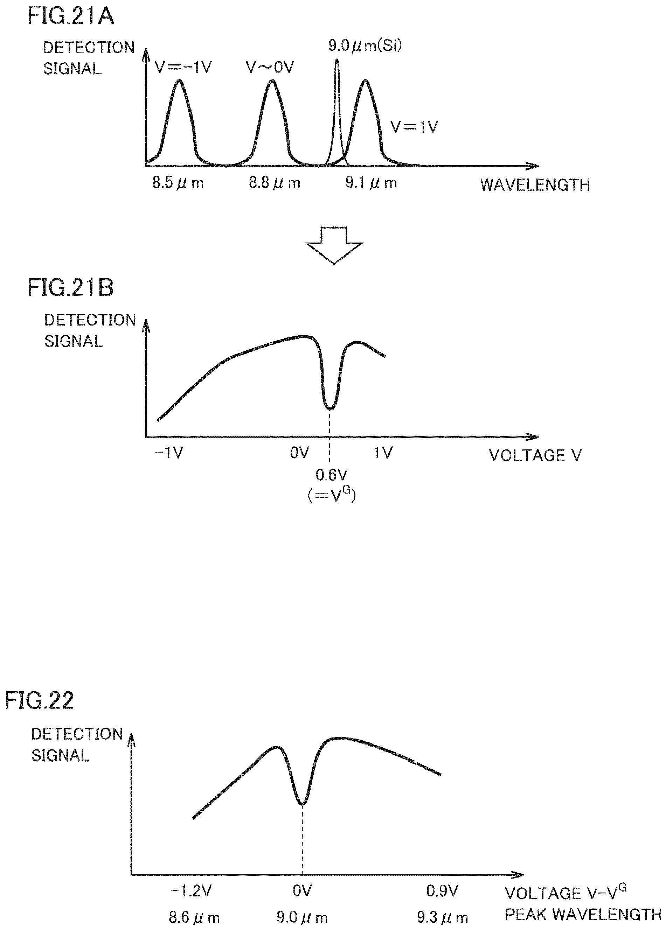

Figs. 21A, 21B, and 22 are diagrams for illustrating a method of calibrating an infrared photodetector according to the present invention. In the example shown in Figs. 20A, 20B, and 20C, the detection wavelength of 9.0 µm at the application voltage of 0 V is set as the target specification. As shown in Fig. 21A, however, when voltage V is set to 0 V, a detection peak of the infrared photodetector is exhibited at 8.8 µm under the influence by a manufacturing error. When solar rays are detected while voltage V applied to the infrared photodetector is varied, a detection signal as shown in Fig. 21B is obtained. The infrared photodetector experiences lowering in detection signal due to absorption by silicon at 0.6 V. The reference voltage for voltage V applied to the infrared photodetector is set to 0.6 V (= V^{G}).

As shown in Fig. 22, when V-V^{G} is set as a value of the application voltage for detecting a target wavelength with respect to voltage V applied to the infrared photodetector, an infrared photodetector which operates as designed is obtained. Variation in manufacturing of the infrared photodetector can thus be calibrated after manufacturing. Instead of "calibration" in which a detection wavelength is measured while a voltage referred to with an absorption peak wavelength of the silicon substrate being defined as the reference voltage is applied, "correction" in which a voltage referred to with the absorption peak wavelength of the silicon substrate being defined as the reference voltage is subtracted from a voltage value in a result of measurement may be performed.

In the example described above, a wavelength used for calibration or correction is set to 9.0 µm representing one of absorption peak wavelengths of the silicon substrate. Calibration or correction, however, may be performed with another absorption peak wavelength (for example, 16.4 µm) of the silicon substrate. A plurality of absorption peak wavelengths of the silicon substrate may naturally be used as the criterions for calibration or correction.

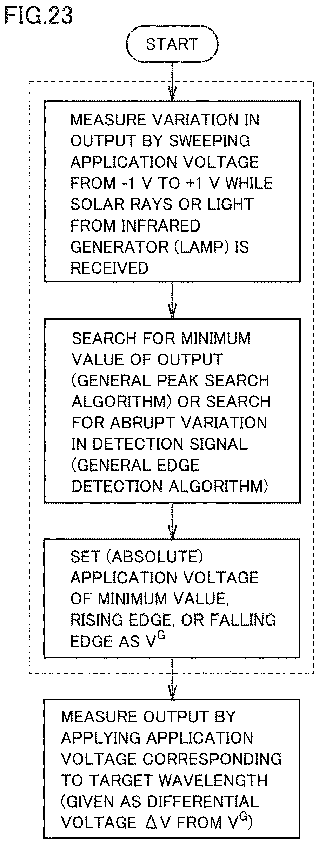

Fig. 23 is a flowchart showing one example of control of the infrared photodetector in Embodiment 6. For example, steps (1) to (4) below are performed for each element.
(1) Variation in output is measured by sweeping a bias voltage (an application voltage) from -1 V to +1 V while outside light (solar rays) or light from the infrared generator (lamp) is received (though a range of sweeping is set to a range from -1 V to +1 V, it is merely by way of example and another range may be used).
(2) A minimum value of an output is searched for (a general peak search algorithm) (the minimum value may be a relative minimum value) or abrupt variation in detection signal is searched for (a general edge detection algorithm).
(3) An (absolute) application voltage of a minimum value, a rising edge, or a falling edge is set as V^{G}.
(4) An output is measured by applying an application voltage corresponding to a target wavelength (given as differential voltage ΔV from V^{G}).

The steps (1) to (3) may be performed each time calibration is performed or may be performed only once in an initial stage.

Preferably, the method of calibrating an infrared photodetector according to the present invention includes the step of applying a voltage at an offset value to the infrared photodetector including the photoelectric conversion unit containing a quantum well or quantum dots. For example, the configuration may be such that a voltage at an offset value appropriate for calibration is measured before shipment of a product, the voltage at the offset value is stored, and the voltage at the stored offset value is applied in use. Even in the configuration as in the example described above, instead of measurement of an absorption peak wavelength of the silicon substrate at each time of use, the configuration may be such that a voltage at an offset value appropriate for calibration is measured before shipment of a product and the voltage at the offset value is applied in use. The infrared photodetector may be configured such that a calibration attachment is attachable. The configuration may be such that a voltage value at an offset value appropriate for calibration can be updated by measuring an absorption peak wavelength of the silicon substrate by attaching the calibration attachment, however, the infrared photodetector is normally used without the calibration attachment being attached thereto.

Though the silicon substrate has been described by way of example in the example described above, the substrate may be composed of a resin. Suitable resins include, for example, polyethylene, polypropylene, polybutylene terephthalate, polyester, polystyrene, polyvinyl chloride, and an acrylic resin, and advantageously, a wavelength absorbed by a substrate which is defined as the criterion for calibration or correction can be adjusted in accordance with a detection wavelength.

### <Embodiment 7>

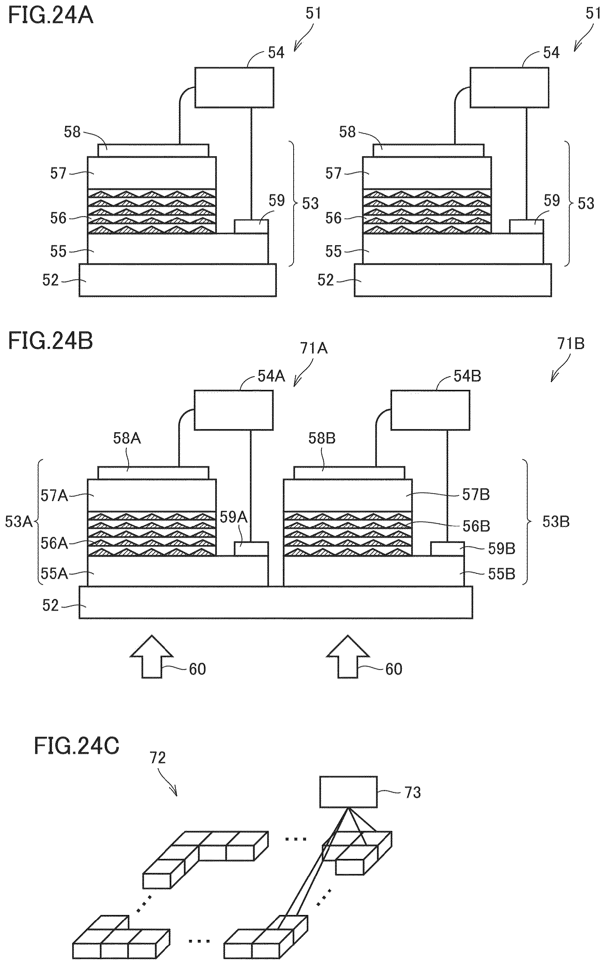

Figs. 24A and 24B are schematic diagrams for illustrating use of a plurality of infrared photodetectors. In this case, a plurality of infrared photodetectors 51 shown in Fig. 15 may be used as the infrared photodetector to be used, as in the example shown in Fig. 24A (infrared photodetectors cut from the same substrate or different substrates), or a plurality of infrared photodetectors formed on the same substrate may be applicable as in the example shown in Fig. 24B. The present invention also provides a detection device including a plurality of detectors according to the present invention described above, in which a wavelength to be referred to as the criterion for calibration or correction of a detection wavelength of each detector is identical. According to the detection device in the present invention, variation in manufacturing of the detection device can efficiently be calibrated or corrected in a simplified manner and production of an error in a result of measurement provided to a user can be prevented.

Fig. 24B shows an example (an infrared photodetector array) in which a quantum dot infrared photodetector 71A constituted of a lower contact layer 55A composed of n-GaAs, an upper contact layer 57A composed of n-GaAs, electrodes 58A and 59A composed of AuGeNi/Au, and an InₓGa₁₋ₓAs quantum dot (0 ≤ x ≤ 1)/In_{y}Ga_{1-y}As (0 ≤ y < 1)/Al_{z}Ga_{1-z}As (0 ≤ z ≤ 1) matrix 56A, and an operation unit/detection unit 54A and a quantum dot infrared photodetector 71B constituted of a lower contact layer 55B composed of n-GaAs, an upper contact layer 57B composed of n-GaAs, electrodes 58B and 59B composed of AuGe/Ni/Au, and an InₓGa₁₋ₓAs quantum dot (0 ≤ x ≤ 1)/In_{y}Ga_{1-y}As (0 ≤ y < 1)/Al_{z}Ga_{1-z}As (0 ≤ z ≤ 1) matrix 56B, and an operation unit/detection unit 54B are integrated on substrate 52, with a buffer layer (not shown) being interposed.

As schematically shown in Fig. 24C, a plurality of infrared photodetectors may be arrayed to implement an imaging device 72. An individual infrared photodetector in imaging device 72 shown in Fig. 24C is as described in Embodiment 6, however, the operation unit and the detection unit may integrally be provided in common to implement an integrated operation unit/integrated detection unit 73.

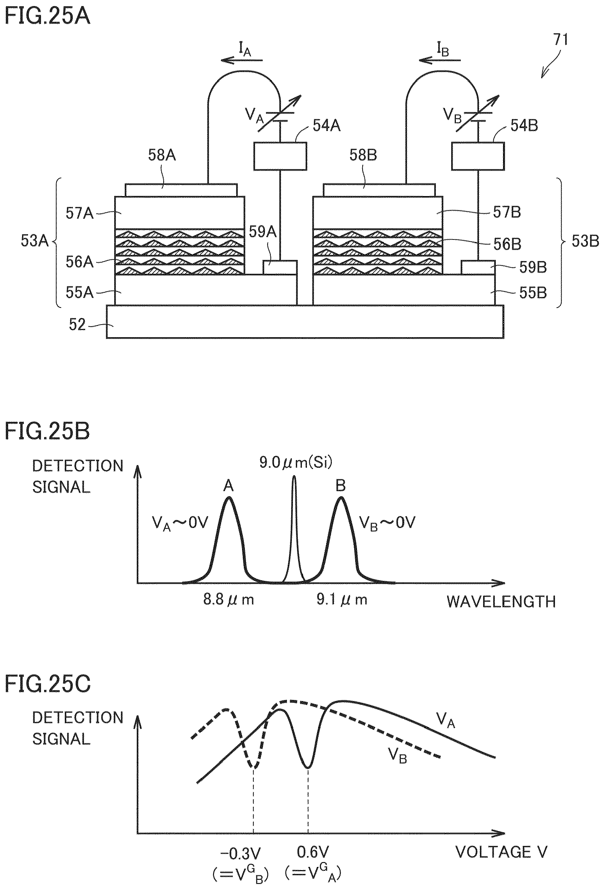

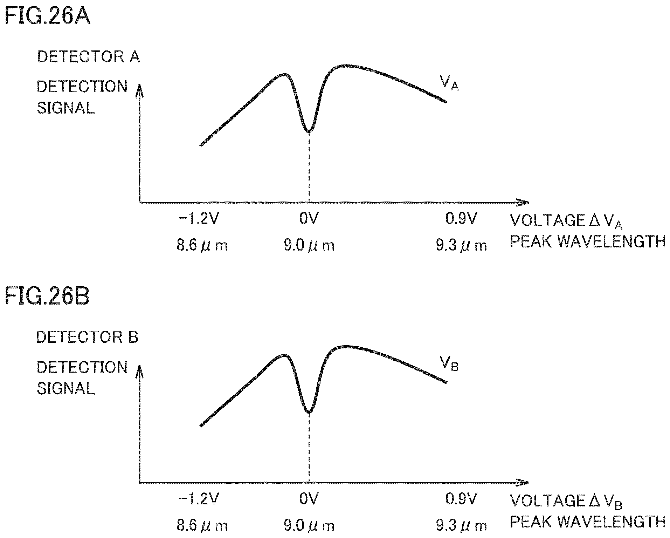

Figs. 25A, 25B, 25C, 26A, and 26B are diagrams for illustrating a calibration method when a plurality of infrared photodetectors as shown in Figs. 24A, 24B, and 24C are used. Fig. 25A is a diagram schematically showing an infrared photodetector array being electrically connected to a power supply, the infrared photodetector array including two infrared photodetectors as shown in Fig. 24B as being integrated. As shown in Fig. 25B, when a voltage is in the vicinity of V ∼ 0 V (strictly speaking, not 0 V) (in Fig. 25B, V_{A} ∼ 0 V and V_{B} ∼ 0 V), under the influence by a manufacturing error, detector A (infrared photodetector 71A) has a detection peak at 8.8 µm and detector B (infrared photodetector 71B) has a detection peak at 9.1 µm. When solar rays are detected while voltages V_{A} and V_{B} of respective infrared photodetector 71A and infrared photodetector 71B are varied, detection signals as shown in Fig. 25C are obtained. Infrared photodetector 71A experiences lowering in detection signal due to absorption by the silicon substrate at 0.6 V (=V^{G}_{A}) and infrared photodetector 71B experiences lowering in detection signal due to absorption by the silicon substrate at -0.3 V (= V^{G}_{B}). The reference voltages for voltages V applied to infrared photodetector 71A and infrared photodetector 71B are set to V^{G}_{A} and V^{G}_{B}, respectively.

When voltages applied to infrared photodetectors 71A and 71B are defined as differences from V^{G}_{A} and V^{G}_{B} (ΔV_{A} and ΔV_{B}), detection peak wavelengths of infrared photodetector 71A and infrared photodetector 71B substantially match with each other when a condition of ΔV_{A} = ΔV_{B} is satisfied. Figs. 26A and 26B show detection spectra of infrared photodetector 71A and infrared photodetector 71B when solar rays are detected. In Fig. 26A, the ordinate represents a detection signal from infrared photodetector 71A and the abscissa represents a differential voltage value (ΔV_{A}) from V^{G}_{A}. In Fig. 26B, the ordinate represents a detection signal from infrared photodetector 71B and the abscissa represents a differential voltage value (ΔV_{B}) from V^{G}_{B}. As can be seen in Figs. 26A and 26B, with V^{G}_{A} and V^{G}_{B} being defined as the reference voltages, a difference in detection peak due to a manufacturing error of infrared photodetector 71A and infrared photodetector 71B can be compensated for in a simplified manner by shifting a position of a detection peak by applying a voltage. In the method of calibrating an infrared photodetector according to the present invention, preferably, variation in detection peak in an individual infrared photodetector is corrected by setting a wavelength absorbed by the substrate as the reference voltage for the voltage applied to the infrared photodetector. Here, by shifting the position of the detection peak by applying a voltage to the infrared photodetector with a difference from the reference voltage being defined as the voltage value, variation in detection peak in a direction of wavelength in application of the voltage can be prevented. Preferably, variation in sensitivity of each infrared photodetector is detected from the detection signal when the reference voltage is set and signal processing for compensating for variation in sensitivity of each infrared photodetector is performed. By doing so, when a plurality of detectors detect different wavelengths and compare the wavelengths or when the detectors are arrayed for imaging, production of an error in a result of measurement provided to a user due to variation in detection wavelength can be prevented.

Though two integrated infrared photodetectors 71A and 71B are exemplified as the detectors according to the present invention, three or more infrared photodetectors may be integrated and a method of calibrating an infrared photodetector according to the present invention may be applied for the purpose of matching detection wavelengths of a plurality of infrared photodetectors which are not integrated.

### <Embodiment 8>

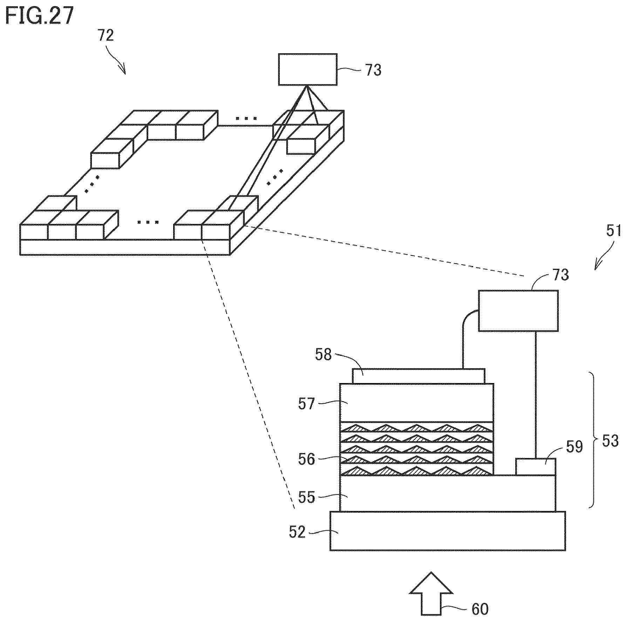

Fig. 27 is a diagram schematically showing an example in which a plurality of infrared photodetectors are arrayed to form imaging device 72. Imaging device 72 in the example shown in Fig. 27 is the same as imaging device 72 schematically shown in Fig. 24C, and an individual infrared photodetector is as described in Embodiment 6. The operation unit and the detection unit, however, are provided in common to implement integrated operation unit/integrated detection unit 73. The integrated operation unit is a unit for operating an application voltage to an individual infrared photodetector and configured to apply equal application voltages to individual infrared photodetectors. The integrated detection unit is configured to integrate results of detection from individual detection units and to calibrate or correct the imaging device as a whole by means of the integrated operation unit.

An exemplary value for reference voltage V^{G} obtained by the integrated detection unit and obtained in calibration of each infrared photodetector as described above in Embodiments 6 and 7 is shown below.

| (Detection Number) | (V^{G}) |
|---|---|
| 1 | 0.02 V |
| 2 | -0.3 V |
| 3 | -0.2 V |
| ... | |
| N | 0.2 V |

The integrated operation unit should only set an application voltage for each infrared photodetector based on these values. The application voltage may be set for an individual infrared photodetector, or an average value of reference voltages V^{G} may be set as an offset voltage of an external circuit and deviation from the average value may be adjusted by a circuit associated with the individual infrared photodetector.

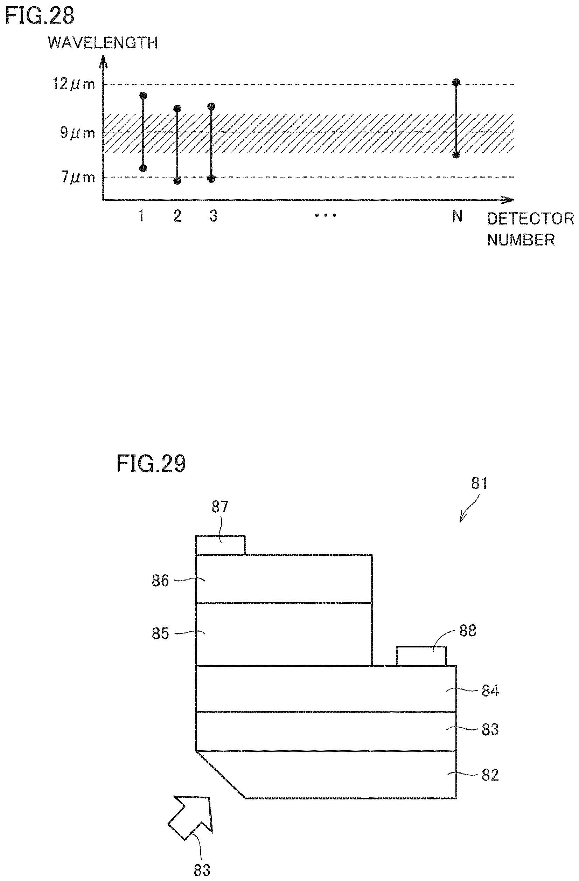

An application voltage to be applied to the infrared photodetector is limited so as not to break the infrared photodetector. Fig. 28 shows a range of wavelengths which can be detected by each infrared photodetector within a range between limits of application voltages as a result of calibration in Embodiments 6 and 7 as described above.

The integrated operation unit sets again a range of application voltages to be applied to the infrared photodetector based on the range of wavelengths (a hatched region) which can be detected by all infrared photodetectors. For example, the limit of the application voltage is assumed as ± 2 V. When reference voltage V^{G} described above is applied as the application voltage to the individual infrared photodetectors, the limit of the application voltage to each infrared photodetector is ± 2 V - V^{G}. Based thereon, the integrated operation unit sets a range of voltages that can be applied to all infrared photodetectors. Even when the application voltage is adjusted with an application voltage of the external circuit and the circuit associated with the individual infrared photodetector, the application voltage can be within a range not causing break of the detector with a similar method.

### <Embodiment 9>

Fig. 29 is a diagram schematically showing an infrared photodetector 81 in another preferred example of the present invention. Infrared photodetector 81 in the example shown in Fig. 29 is a quantum well infrared photodetector (QWIP) including a photoelectric conversion unit constituted of a substrate (for example, a silicon substrate) 82, a buffer layer 83, a lower contact layer 84 composed of n-GaAs, an upper contact layer 86 composed of n-GaAs, and an active layer 85 composed of a GaAs quantum well and an AlₓGa₁₋ₓAs barrier and electrodes 87 and 88 composed of AuGeNi/Au. Active layer 85 in infrared photodetector 81 in the example shown in Fig. 29 is configured to include thirty cycles of the GaAs quantum well having a thickness of 8 nm and the AlₓGa₁₋ₓAs barrier having a thickness of 15 nm. Infrared photodetector 81 in the example shown in Fig. 29 is configured such that an end surface of silicon substrate 82 is polished at 45 degrees and infrared rays 90 can be incident from the end surface polished at 45 degrees. The method of calibrating an infrared photodetector according to the present invention can suitably be applied not only to the quantum dot infrared photodetector (QDIP) in which the active layer contains quantum dots as described above but also to the quantum well infrared photodetector (QWIP) in which the active layer contains the quantum well as shown in Fig. 29.

### <Embodiment 10>

Since detection sensitivity is high when a voltage high to some extent is applied, it may be difficult in the vicinity of V ∼ 0 V to distinguish a wavelength absorbed by the substrate. In the present embodiment, an example in which a wavelength absorbed by the substrate is exhibited at a voltage value distant from V ∼ 0 V is described. Being distant from 0 V should only be that there is a difference from 0 V not less than a resolution of an application voltage of an apparatus.

In this case, a design value of application voltage V0 for detecting a wavelength absorbed by the substrate which is referred to should only be stored. Then, a voltage at a prescribed value (an offset value) should only be set to V^{OFF} = V^{G}-V0 and calibration should only be performed with the method the same as in Embodiment 6.

Thus, the detector according to the present invention may be configured such that a difference between V0 and a value of voltage V^{G} applied to the active layer when a wavelength absorbed by the substrate is exhibited while a value of a voltage applied to the active layer is set to V ∼ V0 is defined as an offset voltage.

### <Embodiment 11>

In the present embodiment, criterion not only to a single wavelength absorbed by the substrate but also to a plurality of wavelengths absorbed by the substrate will be described. An example in which two wavelengths λ1 and λ2 are referred to will be described by way of example below.

When design values of application voltages corresponding to λ1 and λ2 have been known, V1^{OFF} found by referring to λ1 and V2^{OFF} found by referring to λ2 are calculated. An average value of V1^{OFF} and V2^{OFF}, however, may be applied as V^{OFF} to all wavelengths, or relation between the wavelength and an offset voltage may linearly be approximated from λ1 and V1^{OFF} and λ2 and V2^{OFF}. The detector according to the present invention may thus be configured to calibrate or correct a detection wavelength by referring to a plurality of wavelengths absorbed by the substrate.

### <Embodiment 12>

"Correction" in which a voltage referred to with the absorption peak wavelength of the silicon substrate being defined as the reference voltage is subtracted from a voltage value in a result of measurement may be performed. The present invention encompasses not only the method of calibrating a detector but also a method of correcting a detector.

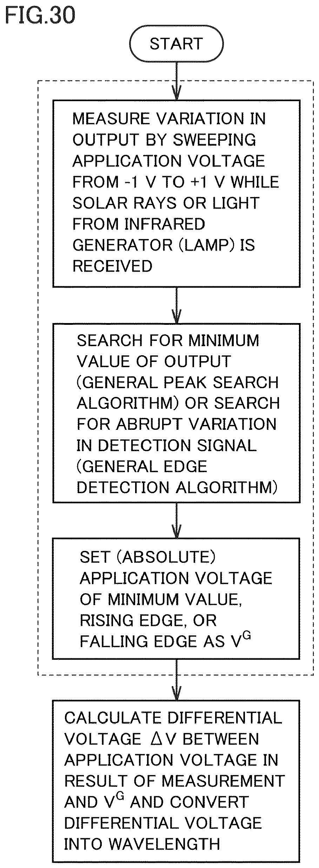

Fig. 30 is a flowchart showing exemplary control of an infrared photodetector in Embodiment 12. For example, steps (1) to (4) below are performed for each element.
(1) Variation in output is measured by sweeping an application voltage from -1 V to +1 V while outside light (solar rays) or light from the infrared generator (lamp) is received.
(2) A minimum value of an output is searched for (a general peak search algorithm) (the minimum value may be a relative minimum value) or abrupt variation in detection signal is searched for (a general edge detection algorithm).
(3) An (absolute) application voltage of a minimum value, a rising edge, or a falling edge is set as V^{G}.
(4) Differential voltage ΔV between the application voltage in the result of measurement and V^{G} is calculated and converted into a wavelength.

The flowchart shown in Fig. 30 is different from the flowchart shown in Fig. 23 in step (4). Instead of measurement by application of an application voltage while V^{G} is provided as the offset value, the value of the application voltage in the result of measurement in (1) is corrected with V^{G}.

In particular, when infrared photodetectors are arrayed, correction of data after measurement is advantageously simpler rather than setting of an offset value for an individual element.

The correction method described in the present embodiment can also be used in the configuration in which a median in a range of application voltages is set as V^{G} in Embodiment 6, the configuration in which V^{G} is distant from 0 V in Embodiment 4, and the configuration in which two detection values are referred to in Embodiment 5.

### <Embodiment 13>

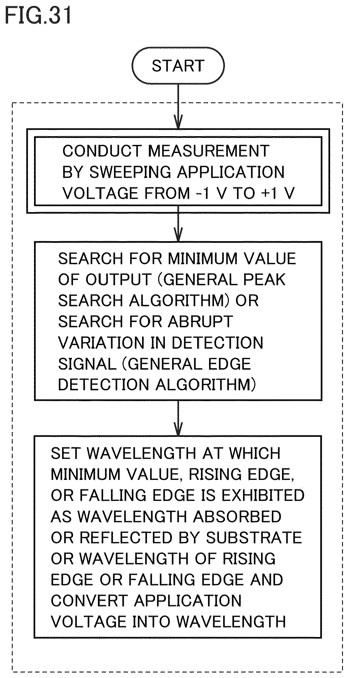

In the present embodiment, a result of measurement is corrected without determining application voltage V^{G}. Fig. 31 is a flowchart showing exemplary control of an infrared photodetector in Embodiment 13. For example, steps (1) to (3) below are performed for each element.
(1) Measurement is conducted by sweeping an application voltage from -1 V to +1 V.
(2) A minimum value of an output is searched for (a general peak search algorithm) (the minimum value may be a relative minimum value) or abrupt variation in detection signal is searched for (a general edge detection algorithm).
(3) An application voltage is converted to a wavelength such that a wavelength at which the minimum value, the rising edge, or the falling edge is exhibited matches with a wavelength at which a transmittance of the substrate exhibits the relative minimum value, the rising edge, or the falling edge. This is equivalent to application of an offset wavelength in converting an application voltage to a wavelength.

In the flowchart shown in Fig. 31, the step of determining application voltage V^{G} is not provided but the voltage is converted as it is to a wavelength. By doing so, advantageously, the number of steps is smaller, it is not necessary to hold (store) V^{G}, and simplification is achieved.

It should be understood that the embodiments and the examples disclosed herein are illustrative and non-restrictive in every respect. The scope of the present invention is defined by the terms of the claims rather than the description above and is intended to include any modifications within the scope and meaning equivalent to the terms of the claims.

## Claims

1. A detector (11A, 11B, 51) comprising:
an active layer containing a quantum well or quantum dots (14A, 14B, 56),
the detector (11A, 11B, 51) being capable of shifting a detection wavelength by applying a voltage to the active layer,
the detector (11A, 11B, 51) having a reference wavelength to be referred to as a criterion for calibration or correction of the detection wavelength within a wavelength region in which the detection wavelength can be shifted.

2. The detector (11A, 11B, 51) according to claim 1, the detector (11A, 11B, 51) being configured to calibrate or correct the detection wavelength with the reference wavelength being defined as the criterion.

3. The detector (11A, 11B, 51) according to claim 1 or 2, wherein
the reference wavelength is a wavelength when a detection value from the detector (11A, 11B, 51) exhibits a relative maximum value, a relative minimum value, a rising edge, or a falling edge.

4. The detector (11A, 11B, 51) according to claim 3, the detector (11A, 11B, 51) being configured to calibrate or correct the detection wavelength with a value of the voltage applied to the active layer when the detection value exhibits the relative maximum value, the relative minimum value, the rising edge, or the falling edge.

5. The detector (11A, 11B, 51) according to any one of claims 1 to 4, the detector (11A, 11B, 51) being configured to set a wavelength at which a value of the voltage applied to the active layer is detected at a median which is substantially at a center of a range of applied voltages as the reference wavelength and to set a difference between the value of the voltage applied to the active layer when a detection value from the detector (11A, 11B, 51) exhibits a relative maximum value, a relative minimum value, a rising edge, or a falling edge and the median as an offset voltage.

6. The detector (11A, 11B, 51) according to any one of claims 1 to 5, the detector (11A, 11B, 51) being configured to calibrate or correct the detection wavelength with a plurality of reference wavelengths.

7. The detector (11A, 11B, 51) according to any one of claims 1 to 6, the detector (11A, 11B, 51) being configured to set a wavelength detected when a value of the voltage applied to the active layer is set to a value other than 0 V as one of reference wavelengths.

8. The detector (11A, 11B, 51) according to any one of claims 1 to 7, the detector (11A, 11B, 51) being capable of detecting infrared rays, wherein
an absorption spectrum specific to a gas is defined as the reference wavelength.

9. The detector (11A, 11B, 51) according to claim 8, wherein
the gas is contained in air.

10. The detector (51) according to claim 1, the detector further comprising a substrate (52), wherein
the reference wavelength is a wavelength at which a transmittance of the substrate (52) exhibits a relative maximum value, a relative minimum value, a rising edge, or a falling edge.

11. The detector (51) according to claim 10, the detector (51) being configured to calibrate or correct the detection wavelength with a wavelength at which the transmittance of the substrate (52) exhibits the relative maximum value, the relative minimum value, the rising edge, or the falling edge being defined as the criterion.

12. The detector (51) according to claim 10 or 11, wherein
a photoelectric conversion unit (53) including the active layer containing the quantum well or the quantum dots (56) is integrally formed on the substrate (52).

13. The detector according to claim 10 or 11, wherein
the substrate is provided separately from a photoelectric conversion unit including the active layer containing the quantum well or the quantum dots.

14. The detector (51) according to any one of claims 10 to 13, wherein
the substrate (52) is composed of silicon.

15. A method of calibrating or correcting a detection wavelength with a reference wavelength being defined as a reference, with the detector (11A, 11B, 51) according to any one of claims 1 to 14.
